# EUROPEAN PATENT SPECIFICATION

(11) **EP 3 961 676 B1**
(45) Date of publication and mention of the grant of the patent: **22.01.2025**
(21) Application number: 21192215.8
(22) Date of filing: 19.08.2021
(51) Int. Cl.: H01L 21/308, H01L 21/306, G03F 7/004, G03F 7/023, G03F 7/038, G03F 7/039, G03F 7/16, G03F 7/40, G03F 7/42

(54) **ETCHING METHOD AND PHOTOSENSITIVE RESIN COMPOSITION**
ÄTZVERFAHREN UND LICHTEMPFINDLICHE HARZZUSAMMENSETZUNG
PROCÉDÉ DE GRAVURE ET COMPOSITION DE RÉSINE PHOTOSENSIBLE

(30) Priority: 26.08.2020 JP 2020143017
(43) Date of publication of application: 02.03.2022
(73) Proprietor: TOKYO OHKA KOGYO CO., LTD., Kawasaki-shi, Kanagawa 211 0012 (JP)
(72) Inventor: UEMATSU, Teruhiro, Kawasaki-shi, Kanagawa 211-0012 (JP)
(74) Representative: Plasseraud IP

(56) References cited:
- US-A1- 2003 039 921
- US-A1- 2007 009 833
- US-A1- 2020 098 582

## Description

This application is based on and claims the benefit of priority from Japanese Patent Application No. 2020-143017, filed on 26 August 2020.

### BACKGROUND OF THE INVENTION

### Field of the Invention

The present invention relates to a method for etching a semiconductor substrate, etc. and a photosensitive resin composition used in the etching method.

### Related Art

As a method for forming holes or grooves in semiconductor substrates, a method is known, in which a protective film having a patterned shape corresponding to the shape of the holes or grooves to be formed is formed and a semiconductor substrate is etched using this as a mask. As the etching method, there is a MAC Etching (Metal-Assisted Chemical Etching) method in which a semiconductor substrate is etched using a noble metal as a catalyst. In Patent Document 1, a technique of etching a semiconductor substrate by a MAC Etching method using an etchant is disclosed.

Patent Document 1: Japanese Unexamined Patent Application, Publication No. 2019-140225

In Patent Documeent 2 an etching method is disclosed, comprising:a coating step of forming a coating film by applying a photosensitive resin composition to a substrate, an exposure step of position-selectively exposing the coating film, a developing step of developing the coating film after exposure to expose a part of the substrate and obtain a patterned cured product, an etching step of etching the substrate to form a hole or groove in the substrate, with the etching being performed in the presence of a noble metal catalyst using the patterned cured product as a mask and an aqueous solution including a corrosive agent and an oxidizing agent as an etchant, and a stripping step of stripping the patterned cured product after the etching step, from the substrate,wherein the photosensitive resin composition comprises a resin (A), a photosensitizer (B), and a solvent (S), and wherein the resin (A) is a novolak resin.

Patent Documeent 2: US 2020/098582 A1.

### SUMMARY OF THE INVENTION

However, in the technique of Patent Document 1, there is a problem that a hole having a small diameter (including a through-hole) or a groove having a narrow width (including a through-groove) cannot be often formed in the semiconductor substrate.

In view of the above problem, it is an object of the present invention to provide an etching method capable of forming a hole having a small diameter or a groove having a narrow width in a substrate using an etchant, and a photosensitive resin composition that is used in the etching method.

The present inventors have found that a patterned cured product can be by the present invention. even when a mask having a fine transfer pattern is formed, the mask has good etching resistance, and it is possible to form a hole having a small diameter or a groove having a narrow width in the substrate, thereby completing the present invention. Accordingly, the present invention provides the following.

A first aspect of the present invention relates to an etching method defined in claim 1,

A second aspect of the present invention relates to a photosensitive resin composition for use in the etching method as described in the first aspect.

According to the present invention, it is possible to provide an etching method capable of forming a hole having a small diameter or a groove having a narrow width in a substrate using an etchant, and to provide a photosensitive resin composition for use in the etching method.

### BRIEF DESCRIPTION OF THE DRAWINGS

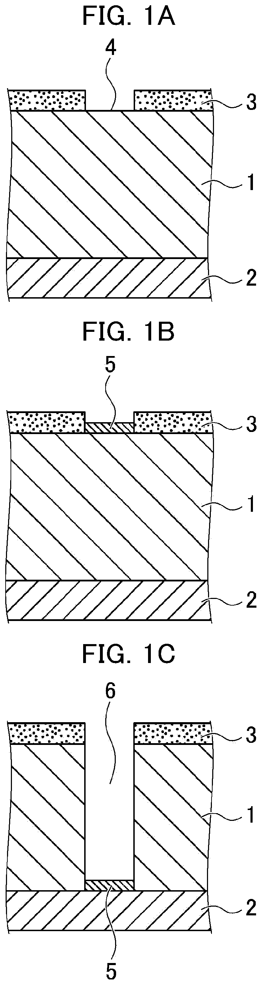

FIG. 1A is a schematic cross-sectional view showing an example of the etching method of the present invention.
FIG. 1B is a schematic cross-sectional view showing an example of the etching method of the present invention.
FIG. 1C is a schematic cross-sectional view showing an example of the etching method of the present invention.

### DETAILED DESCRIPTION OF THE INVENTION

Each method step will be specifically described below with reference to Figs. 1A to 1C. Figs. 1A to 1C are schematic sectional views showing an example of the etching method of the present invention, and illustrating an example in which a groove (through-groove) that penetrates the substrate and that is for dicing the semiconductor substrate is formed. Note that the hole or groove formed in the substrate by the etching method of the present invention may or may not penetrate the substrate. In the present invention, the "hole" is a concept including a through-hole and a hole which does not fully penetrate through, and the "groove" is a concept including a through-groove and a groove which does not fully penetrate through.

### <Coating step>

In the coating step, a photosensitive resin composition is applied to a substrate 1 to form a coating film.

### (Substrate)

Examples of the substrate 1 to which the photosensitive resin composition is applied include a semiconductor substrate. Examples of the semiconductor substrate include a silicon substrate, a germanium substrate, a semiconductor substrate made of a compound composed of a group III element and a group V element, such as gallium arsenide or gallium nitride, and a silicon carbide substrate. Note that "group" refers to a "group" in the short period periodic table. Figs. 1A to 1C show an example in which a dicing tape 2 for dicing is attached to one of the main surfaces of the substrate 1.

The thickness of the substrate 1 may be appropriately selected depending on the purpose of processing. The thickness of the substrate 1 is, for example, 10 um or more and 700 um or less. In consideration of handling property and the like, the thickness of the substrate 1 is, for example, 100 um or more, and is preferably 200 um or more, but the substrate 1 can be processed by using a supporting material or the like even if the thickness of the substrate 1 is less than 100 um or less than 200 µm.

### (Photosensitive resin composition)

The photosensitive resin composition to be applied to the substrate 1 includes a resin (A), a photosensitizer (B), and a solvent (S). In the photosensitive resin composition, the resin (A) is a novolak resin. The substrate 1 is etched in the presence of a noble metal catalyst, using, as the mask (protective film), a patterned cured product obtained by coating, exposing and developing a photosensitive resin composition containing a novolak resin as the resin (A), and using an aqueous solution containing a corrosive agent and an oxidizing agent as the etchant. When forming a mask having a fine transfer pattern to form a hole having a small diameter or a groove having a narrow width in the substrate, there is a problem that during etching, deterioration of the mask such as the mask peeling off from the substrate occurs, and therefore it is difficult to form desired fine holes or grooves. For example, in a case in which in order to form a hole or groove having a large aspect ratio (depth/(diameter or width)), the mask is contacted with the etchant for a long time, such as a case in which etching is performed so that the hole or groove penetrates a thick substrate 1 or a deep hole or groove is formed in the substrate 1, this problem is particularly serious. However, as shown in the examples described below, the above photosensitive resin composition provides a cured product (mask) having extremely excellent resolution and extremely high etching resistance (resistance to etchant). Therefore, by forming the mask using the above-described photosensitive resin composition, even when a cured product (mask) having a fine transfer pattern is formed, etching resistance (wet etching resistance) of the cured product (mask) is good; the mask does not peel off from the substrate 1 during etching for a long time; a pattern shape of the mask having fine holes or grooves can be maintained; and a hole having a diameter of, for example, 10 um or less or a groove having a width of 10 µm or less can be formed in the substrate 1 in a satisfactory manner. For example, it is possible to form a hole or groove having an aspect ratio of 1 or more in the substrate 1, including to form a through-hole or a through-groove in a thick substrate 1, or to form a deep hole or groove in the substrate 1. On the other hand, when the photosensitive resin composition contains a resin other than the novolak resin such as, for example, an acrylic resin, a polyhydroxystyrene, a polyimide, a fluororesin, or a phenol resin, at least one of the resolution of the photosensitive resin composition and the etching resistance of the mask formed is often inferior. Therefore, it is difficult to form a hole having a diameter of 10 um or less a groove having width of 10 um or less as described above in the substrate.

The photosensitive resin composition may be a chemically amplified positive-type photosensitive resin composition or a chemically amplified negative-type photosensitive resin composition, or may be a positive-type photosensitive resin composition which is not a chemically amplified type.

The chemically amplified positive-type photosensitive resin composition is typically a photosensitive resin composition containing an acid generator as the photosensitizer (B) and a novolak resin in which at least a part of phenolic hydroxy groups is protected by an acid-dissociable dissolution-inhibiting group as a resin whose solubility in alkali is increased by the action of an acid generated from the acid generator by exposure. Further, the chemically amplified positive-type photosensitive resin composition may be a photosensitive resin composition including an acid generator as the photosensitizer (B), a novolak resin in which at least a part of the phenolic hydroxy groups may be protected by an acid-dissociable dissolution-inhibiting group, and a protecting agent which gives an acid-dissociable dissolution-inhibiting group by reacting with a phenolic hydroxy group.

A novolak resin whose phenolic hydroxyl group to be protected by an acid-dissociable dissolution-inhibiting group is not particularly limited and can be appropriately selected from well-known novolak resins. As the novolak resin whose phenolic hydroxy group is protected by an acid-dissociable dissolution-inhibiting group, a resin including a constituent unit having a phenolic hydroxy group protected by an acid-dissociable dissolution-inhibiting group represented by the following formula (a1) can be used.

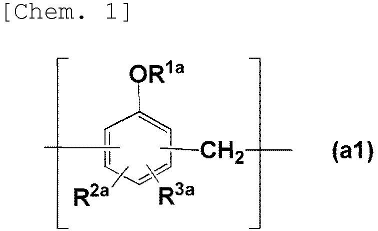

In the above formula (a1), R^{1a} represents an acid-dissociable dissolution-inhibiting group, and R^{2a} and R^{3a} each independently represents a hydrogen atom or an alkyl group having 1 or more and 6 or less carbon atoms.

The acid-dissociable dissolution-inhibiting group represented by R^{1a} is preferably groups represented by the following formulae (a2) and (a3), a linear, branched, or cyclic alkyl group having 1 or more and 6 or less carbon atoms, a vinyloxy ethyl group, a tetrahydropyranyl group, a tetrahydrofuranyl group, or a trialkylsilyl group.

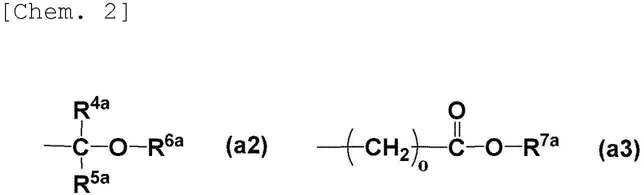

In the above formulae (a2) and (a3), R^{4a} and R^{5a} each independently represents a hydrogen atom or a linear or branched alkyl group having 1 or more and 6 or less carbon atoms, R^{6a} represents a linear, branched, or cyclic alkyl group having 1 or more and 10 or less carbon atoms, R^{7a} represents a linear, branched, or cyclic alkyl group having 1 or more and 6 or less carbon atoms, and o represents 0 or 1.

Examples of the above linear or branched alkyl group include a methyl group, an ethyl group, a propyl group, an isopropyl group, a n-butyl group, an isobutyl group, a tert-butyl group, a pentyl group, an isopentyl group, a neopentyl group, and the like. Furthermore, examples of the above cyclic alkyl group include a cyclopentyl group, a cyclohexyl group, and the like.

Herein, specific examples of the acid-dissociable dissolution-inhibiting group represented by the above formula (a2) include a methoxyethyl group, an ethoxyethyl group, a n-propoxyethyl group, an isopropoxyethyl group, a n-butoxyethyl group, an isobutoxyethyl group, a tert-butoxyethyl group, a cyclohexyloxyethyl group, a methoxypropyl group, a ethoxypropyl group, a 1-methoxy-1-methyl-ethyl group, a 1-ethoxy-1-methylethyl group, and the like. Furthermore, specific examples of the acid-dissociable dissolution-inhibiting group represented by the above formula (a3) include a tert-butoxycarbonyl group, a tert-butoxycarbonylmethyl group, and the like. Furthermore, examples of the above trialkylsilyl group include a trimethylsilyl group and a tri-tert-butyldimethylsilyl group in which each alkyl group has 1 or more and 6 or less carbon atoms.

The acid-dissociable dissolution-inhibiting group is preferably a divalent acid-dissociable dissolution-inhibiting group derived from a divinyl ether compound represented by the formula (I).

H₂C=CH-O-A^{a1}-O-CH=CH₂ ··· (I)

In the formula (I), A^{a1} is an alkylene group having 1 or more and 10 or less carbon atoms, optionally having a substituent and optionally including an ether bond in the main chain, or a group represented by the following formula (II):

- (A^{a2})ₙₐ-A^{a3}-(A^{a2})ₙₐ- ··· (II),

wherein, in the formula (II), A^{a2} is an alkylene group having 1 or more and 10 or less carbon atoms, optionally having a substituent; A^{a3} is a cyclohexylene group; and na is 0 or 1.

When both ends of the divinyl ether compound represented by the formula (I) are reacted with two of the phenolic hydroxy groups of the novolak resin, a divalent acid-dissociable dissolution-inhibiting group derived from the divinyl ether compound represented by the formula (I) is generated. The divalent acid-dissociable dissolution-inhibiting group derived in the divinyl ether compound represented by the formula (I) is a group represented by the following formula (Ia):

-CH(CH₃)-O-A^{a1}-O-CH(CH₃)- ··· (Ia).

Furthermore, when only one end of the divinyl ether compound represented by the formula (I) is reacted with a phenolic hydroxy group of the novolak resin, a monovalent acid-dissociable dissolution-inhibiting group represented by the following formula (Ib):

-CH(CH₃)-O-A^{a1}-O-CH=CH₂ ··· (Ib)

is generated. A^{a1} in the formulae (Ia) and (Ib) is the same as A^{a1} in the formula (I) .

When A^{a1} in the formula (I) is an alkylene group having 1 or more and 10 or less carbon atoms, optionally having a substituent and optionally including an ether bond in the main chain, examples of the substituent which the alkylene group may have include halogen atoms such as a chlorine atom, a bromine atom, and a fluorine atom, and alkoxy groups such as a methoxy group and an ethoxy group.

The alkylene group as A^{a1} in the formula (I) may include an ether bond (-O-) in the chain. When A^{a1} is an alkylene group optionally having an ether bond in the chain, the number of carbon atoms is 1 or more and 10 or less, preferably 1 or more and 8 or less, and more preferably 2 or more and 6 or less. Suitable specific examples of the alkylene group as A^{a1} optionally having an ether bond in the main chain include - CH₂CH₂CH₂CH₂-, -CH₂CH₂-O-CH₂CH₂-, and -CH₂CH₂-O-CH₂CH₂-O-CH₂CH₂-.

A divalent group represented by the above formula (II) is also preferable as A^{a1}. In the formula (II), A^{a3} is a cyclohexylene group. The cyclohexylene group may be any of a cyclohexane-1,4-diyl group, a cyclohexane-1,3-diyl group, and a cyclohexane-1,2-diyl group, and a cyclohexane-1,4-diyl group is preferable. In the formula (II), na is independently 0 or 1. In the formula (II), A^{a2} is an alkylene group having 1 or more and 10 or less carbon atoms, optionally having a substituent. The number of carbon atoms of the alkylene group as A^{a2} is preferably 1 or more and 6 or less, more preferably 1 or more and 4 or less, and further preferably 1 or 2. Examples of the substituent which the alkylene group as A^{a2} may have include halogen atoms such as a chlorine atom, a bromine atom, and a fluorine atom, and alkoxy groups such as a methoxy group and an ethoxy group. Suitable specific examples of the alkylene group as A^{a2} include a methylene group, an ethane-1,2-diyl group, an ethane-1,1-diyl group, a propane-1,3-diyl group, a butane-1,4-diyl group, and the like.

Particularly preferable examples of the divalent group represented by the formula (II) include a group in which both of the two na are 1, A^{a3} is a cyclohexane-1,4-diyl group, and two A^{a2} are a methylene group.

The ratio (protection ratio) of the number of hydroxy groups protected by the acid-dissociable dissolution-inhibiting group derived from the divinyl ether compound represented by the formula (I), which is represented by the above formula (Ia) and/or the formula (Ib), to the number of all the phenolic hydroxy group of the novolak resin is preferably 0.5% or more and 30% or less, preferably 1% or more and 20% or less, and further preferably 2% or more and 10% or less, from the viewpoint of characteristics of the etching mask. The protection ratio can be verified by, for example, proton NMR.

The content of the novolak resin is preferably 50% by mass or more and 95% by mass or less, more preferably 55% by mass or more and 90% by mass or less, with respect to the solid content of the chemically amplified positive-type photosensitive resin composition. The above range tends to provide well-balanced developability.

Note that the novolak resin whose phenolic hydroxy group to be protected by an acid-dissociable dissolution-inhibiting group can be obtained by subjecting a phenol and an aldehyde to addition condensation in the presence of an acid catalyst.

Examples of phenols include cresols such as phenol, o-cresol, m-cresol, p-cresol, etc.; xylenols such as 2,3-xylenol, 2,4-xylenol, 2,5-xylenol, 2,6-xylenol, 3,4-xylenol, 3,5-xylenol, etc.; alkyl phenols such as o-ethylphenol, methylphenol, p-ethylphenol, 2-isopropylphenol, 3-isopropylphenol, 4-isopropylphenol, o-butylphenol, m-butylphenol, p-butylphenol, p-tert-butylphenol, etc.; trialkylphenols such as 2,3,5-trimethylphenol, 3,4,5-trimethylphenol, etc.; polyhydric phenols such as resorcinol, catechol, hydroquinone, hydroquinone monomethyl ether, pyrogallol, phloroglucinol, etc.; alkyl polyhydric phenols such as alkylresorcin, alkylcatechol, alkyl hydroquinone, etc. (all of the alkyl groups have 1 to 4 carbon atoms); α-naphthol, β-naphthol, hydroxydiphenyl, bisphenol A, and the like. These phenols may be used alone or in combination of two or more types. Among these phenols, m-cresol and p-cresol are preferred, and m-cresol and p-cresol are more preferably used in combination. In this case, various characteristics such as sensitivity, etc. can be controlled by adjusting the blending ratio of them. For example, m-cresol:p-cresol (molar ratio) is preferably set to 5:5 to 7:3, more preferably set to 5.5:4.5 to 6.5:3.5.

Examples of the aldehydes include formaldehyde, paraformaldehyde, furfural, benzaldehyde, nitrobenzaldehyde, acetaldehyde, etc. These aldehydes may be used alone or in combination of two or more types.

Examples of the acid catalyst include inorganic acids such as hydrochloric acid, sulfuric acid, nitric acid, phosphoric acid, phosphorous acid, etc.; organic acids such as formic acid, oxalic acid, acetic acid, diethyl sulfuric acid, para-toluenesulfonic acid, etc.; and metal salts such as zinc acetate, etc. These acid catalysts may be used alone or in combination of two or more types.

Specific examples of the novolak resins obtained in this way include the following: phenol/formaldehyde condensation novolak resin, cresol/formaldehyde condensation novolak resin, phenol-naphthol/formaldehyde condensation novolak resin, etc.

Of the novolak resins in which at least a part of the phenolic hydroxy groups may be protected by an acid-dissociable dissolution-inhibiting group, the novolak resin in which at least a part of the phenolic hydroxy groups is protected by an acid-dissociable dissolution-inhibiting group is the same as the novolak resin in which at least a part of the phenolic hydroxy groups is protected by the acid-dissociable dissolution-inhibiting group described above. As the novolak resin, it is possible to use the novolak resin in which at least a part of the phenolic hydroxy groups is protected by an acid-dissociable dissolution-inhibiting group, in a state in which the phenolic hydroxy groups protected by an acid-dissociable dissolution-inhibiting group are deprotected.

The protecting agent is a compound which gives an acid-dissociable dissolution-inhibiting group by reacting with a phenolic hydroxy group. The protecting agent is not particularly limited, as long as it is a compound which gives an acid-dissociable dissolution-inhibiting group by reaction with a phenolic hydroxy group. Examples of the acid-dissociable dissolution-inhibiting group include: a methoxyethyl group, an ethoxyethyl group, a n-propoxyethyl group, an isopropoxyethyl group, a n-butoxyethyl group, an isobutoxyethyl group, a tert-butoxyethyl group, a cyclohexyloxyethyl group, a methoxypropyl group, an ethoxypropyl group a 1-methoxy-1-methyl-ethyl group, a 1-ethoxy-1-methylethyl group, a tert-butoxycarbonyl group, a tert-butoxycarbonylmethyl group, a trimethylsilyl group, a tri-tert-butyldimethylsilyl group, etc.

As the protecting agent, a divinyl ether compound represented by the above formula (I) is preferred, because both excellent resistance of the etching mask (cured product) to an etchant and ease of stripping of the etching mask by an organic solvent can be obtained.

The amount of the protecting agent to be used is preferably in a range of 0.5 parts by mass or more and 30 parts by mass or less, more preferably 1 part by mass or more and 20 parts by mass or less, and most preferably 2 parts by mass or more and 10 parts by mass or less, with respect to 100 parts by mass of the novolak resin in which at least a part of the phenolic hydroxy groups may be protected by an acid-dissociable dissolution-inhibiting group, from the viewpoint of film characteristics of the etching mask.

An acid generator contained in the chemically amplified positive-type photosensitive resin composition is a compound capable of generating an acid by irradiation with radiation. The acid generator is not particularly limited as long as it is a compound which directly or indirectly generates an acid under the action of light. The acid generator is preferably any one of the first to fourth acid generators that will be described below. Hereinafter, the first to fourth acid generators will be described.

### (First acid generator)

Examples of a first acid generator include the compound represented by the following formula (b1).

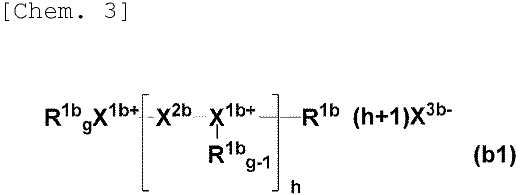

In the above formula (b1), X^{1b} represents a sulfur atom or an iodine atom having a valence of g, and g is 1 or 2. h represents the number of repeating units in the structure within parentheses. R^{1b} represents an organic group that is bonded to X^{1b}, and represents an aryl group having 6 or more and 30 or less carbon atoms, a heterocyclic group having 4 or more and 30 or less carbon atoms, an alkyl group having 1 or more and 30 or less carbon atoms, an alkenyl group having 2 or more and 30 or less carbon atoms or an alkynyl group having 2 or more and 30 or less carbon atoms; and R^{1b} may be substituted with at least one selected from the group consisting of an alkyl group, a hydroxy group, an alkoxy group, an alkylcarbonyl group, an arylcarbonyl group, an alkoxycarbonyl group, an aryloxycarbonyl group, an arylthiocarbonyl group, an acyloxy group, an arylthio group, an alkylthio group, an aryl group, a heterocyclic group, an aryloxy group, an alkylsulfinyl group, an arylsulfinyl group, an alkylsulfonyl group, an arylsulfonyl group, an alkyleneoxy group, an amino group, a cyano group, a nitro group, and halogen atoms. The number of R^{1b}s is g + h(g - 1) + 1, and the R^{1b}s may be the same as or different from each other. Furthermore, two or more R^{1b}s may be bonded to each other directly or via -O-, -S-, -SO-, - SO₂-, -NH-, -NR^{2b}-, -CO-, -COO-, -CONH-, an alkylene group having 1 or more and 3 or less carbon atoms or a phenylene group, and may form a ring structure including X^{1b}. R^{2b} is an alkyl group having 1 or more and 5 or less carbon atoms or an aryl group having 6 or more and 10 or less carbon atoms.

X^{2b} is a structure represented by the following formula (b2) .

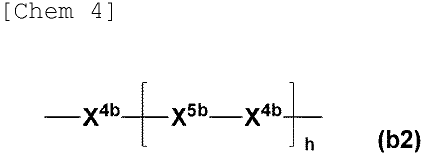

In the above formula (b2), X^{4b} represents an alkylene group having 1 or more and 8 or less carbon atoms, an arylene group having 6 or more and 20 or less carbon atoms, or a divalent group of a heterocyclic compound having 8 or more and 20 or less carbon atoms, and X^{4b} may be substituted with at least one selected from the group consisting of an alkyl group having 1 or more and 8 or less carbon atoms, an alkoxy group having 1 or more and 8 or less carbon atoms, an aryl group having 6 or more and 10 or less carbon atoms, a hydroxy group, a cyano group, a nitro group, and halogen atoms. X^{5b} represents -O-, -S-, -SO-, -SO₂-, -NH-, -NR^{2b}-, -CO-, -COO-, - CONH-, an alkylene group having 1 or more and 3 or less carbon atoms, or a phenylene group. h represents the number of repeating units of the structure in parentheses. X^{4b}s in the number of h + 1 and X^{5b}s in the number of h may be identical to or different from each other. R^{2b} has the same definition as described above.

X^{3b-} is a counterion of the onium, and examples thereof include anion represented by the following formulae (b9), (b13) and (b14), a fluorinated alkylfluorophosphoric acid anion represented by the following formula (b17), or a borate anion represented by the following formula (b18). From the viewpoint of film characteristics of the etching mask, the anion represented by the following formula (b9) is preferable.

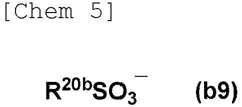

In the above formula (b9), R^{20b} is a group represented by the following formulae (b10), (b11), and (b12).

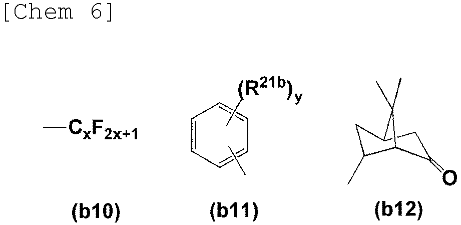

In the above formula (b10), x represents an integer of 1 or more and 4 or less. Furthermore, in the above formula (b11), R^{21b} represents a hydrogen atom, a hydroxy group, a linear or branched alkyl group having 1 or more and 6 or less carbon atoms, or a linear or branched alkoxy group having 1 or more and 6 or less carbon atoms, and y represents an integer of 1 or more and 3 or less. Among them, from the viewpoint of safety, trifluoromethane sulfonate and perfluorobutane sulfonate are preferable.

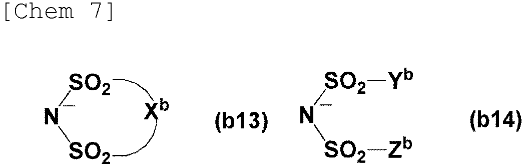

In the above formulae (b13) and (b14), X^{b} represents a linear or branched alkylene group in which at least one hydrogen atom is substituted with a fluorine atom, and the number of carbon atoms of the alkylene group is 2 or more and 6 or less, preferably 3 or more and 5 or less, and most preferably 3. Furthermore, Y^{b} and Z^{b} each independently represents a linear or branched alkyl group in which at least one hydrogen atom is substituted with a fluorine atom, and the number of carbon atoms of the alkyl group is 1 or more and 10 or less, preferably 1 or more and 7 or less, and more preferably 1 or more and 3 or less.

A smaller number of carbon atoms in the alkylene group of X^{b} or in the alkyl group of Y^{b} or Z^{b} is preferable because the solubility into an organic solvent is also favorable.

Furthermore, a larger number of hydrogen atoms each substituted by a fluorine atom in the alkylene group of X^{b} or in the alkyl group of Y^{b} or Z^{b} is preferable because the acid strength becomes greater. The rate of fluorine atoms in the alkylene group or the alkyl group, that is, a fluorination rate, is preferably 70% or more and 100% or less, more preferably 90% or more and 100% or less, and most preferably a perfluoroalkylene group or a perfluoroalkyl group in which all of the hydrogen atoms are substituted with fluorine atoms.

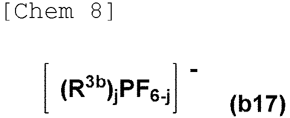

In the above formula (b17), R^{3b} represents an alkyl group in which 80% or more of the hydrogen atoms is substituted with fluorine atoms, j represents the number thereof and is an integer of 1 or more and 5 or less, and R^{3b}s in the number of j may be identical to or different from each other.

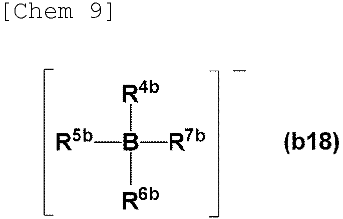

In the above formula (b18), R^{4b} to R^{7b} each independently represents a fluorine atom or a phenyl group, and a part or all of the hydrogen atoms of the phenyl group may be substituted with at least one selected from the group consisting of a fluorine atom and a trifluoromethyl group.

Examples of the onium ion in the compound represented by the above formula (b1) include triphenylsulfonium, tri-p-tolylsulfonium, 4-(phenylthio)phenyldiphenylsulfonium, bis[4-(diphenylsulfonio)phenyl] sulfide, bis[4-{bis[4-(2-hydroxyethoxy)phenyl]sulfonio}phenyl] sulfide, bis{4-[bis(4-fluorophenyl)sulfonio]phenyl} sulfide, 4-(4-benzoyl-2-chlorophenylthio)phenylbis(4-fluorophenyl)sulfonium, 7-isopropyl-9-oxo-10-thia-9,10-dihydroanthrancen-2-yldi-p-tolylsulfonium, 7-isopropyl-9-oxo-10-thia-9,10-dihydroanthracen-2-yldiphenylsulfonium, 2-[(diphenyl)sulfonio]thioxanthone, 4-[4-(4-tert-butylbenzoyl)phenylthio]phenyldi-p-tolylsulfonium, 4-(4-benzoylphenylthio)phenyldiphenylsulfonium, diphenylphenacylsulfonium, 4-hydroxyphenylmethylbenzylsulfonium, 2-naphthylmethyl(1-ethoxycarbonyl)ethylsulfonium, 4-hydroxyphenylmethylphenacylsulfonium, phenyl[4-(4-biphenylthio)phenyl]-4-biphenylsulfonium, phenyl[4-(4-biphenylthio)phenyl]-3-biphenylsulfonium, [4-(4-acetophenylthio)phenyl]diphenylsulfonium, octadecylmethylphenacylsulfonium, diphenyliodonium, di-p-tolyliodonium, bis(4-dodecylphenyl)iodonium, bis(4-methoxyphenyl)iodonium, (4-octyloxyphenyl)phenyliodonium, bis(4-decyloxy)phenyliodonium, 4-(2-hydroxytetradecyloxy)phenylphenyliodonium, 4-isopropylphenyl(p-tolyl)iodonium, 4-isobutylphenyl(p-tolyl)iodonium, or the like.

In regard to the fluorinated alkylfluorophosphoric acid anion represented by the above formula (b17), R^{3b} represents an alkyl group substituted with a fluorine atom, and a preferable number of carbon atoms is 1 or more and 8 or less, while a more preferable number of carbon atoms is 1 or more and 4 or less. Specific examples of the alkyl group include: linear alkyl groups such as methyl, ethyl, propyl, butyl, pentyl and octyl; branched alkyl groups such as isopropyl, isobutyl, sec-butyl and tert-butyl; and furthermore, cycloalkyl groups such as cyclopropyl, cyclobutyl, cyclopentyl and cyclohexyl, and the proportion of hydrogen atoms substituted by fluorine atoms in the alkyl groups is normally 80% or more, is preferably 90% or more and is more preferably 100%. When the substitution rate of fluorine atoms is less than 80%, the acid strength of the onium fluorinated alkylfluorophosphate represented by the above formula (b1) is lowered.

A particularly preferable example of R^{3b} is a linear or branched perfluoroalkyl group having 1 or more and 4 or less carbon atoms and the substitution rate of fluorine atoms of 100%. Specific examples thereof include CF₃, CF₃CF₂, (CF₃)₂CF, CF₃CF₂CF₂, CF₃CF₂CF₂CF₂, (CF₃)₂CFCF₂, CF₃CF₂(CF₃)CF, (CF₃)₃C, and the like. j which is the number of R^{3b}s represents an integer from 1 or more and 5 or less, and is preferably 2 or more and 4 or less, and particularly preferably 2 or 3.

Preferable specific examples of the fluorinated alkylfluorophosphoric acid anion include [(CF₃CF₂)₂PF₄]⁻, [(CF₃CF₂)₃PF₃]⁻, [((CF₃)₂CF)₂PF₄]⁻, [((CF₃)₂CF)₃PF₃]⁻, [(CF₃CF₂CF₂)₂PF₄]⁻, [(CF₃CF₂CF₂)₃PF₃]⁻, [((CF₃)₂CFCF₂)₂PF₄]⁻, [((CF₃)₂CFCF₂)₃PF₃]⁻, [(CF₃CF₂CF₂CF₂)₂PF₄]⁻, or [(CF₃CF₂CF₂)₃PF₃]⁻. Among them, [(CF₃CF₂)₃PF₃]⁻, [(CF₃CF₂CF₂)₃PF₃]⁻, [((CF₃)₂CF)₃PF₃]⁻, [((CF₃)₂CF)₂PF₄]⁻, [((CF₃)₂CFCF₂)₃PF₃]⁻, or [((CF₃)₂CFCF₂)₂PF₄]⁻ is particularly preferable.

Preferable specific examples of the borate anion represented by the above formula (b18) include tetrakis (pentafluorophenyl) borate ([B(C₆F₅)₄]⁻), tetrakis [(trifluoromethyl)phenyl]borate ([B(C₆H₄CF₃)₄]⁻), difluorobis(pentafluorophenyl)borate([(C₆F₅)₂BF₂]⁻), trifluoro (pentafluorophenyl) borate ([(C₆F₅)BF₃]⁻), and tetrakis (difluorophenyl) borate ([B(C₆H₃F₂)₄]⁻). Among these, tetrakis (pentafluorophenyl) borate ([B(C₆F₅)₄]⁻) is particularly preferable.

### (Second acid generator)

The second acid generator includes halogen-containing triazine compounds such as 2,4-bis(trichloromethyl)-6-piperonyl-1,3,5-triazine, 2,4-bis(trichloromethyl)-6-[2-(2-furyl)ethenyl]-s-triazine, 2,4-bis(trichloromethyl)-6-[2-(5-methyl-2-furyl)ethenyl]-s-triazine, 2,4-bis(trichloromethyl)-6-[2-(5-ethyl-2-furyl)ethenyl]-s-triazine, 2,4-bis(trichloromethyl)-6-[2-(5-propyl-2-furyl)ethenyl]-s-triazine, 2,4-bis(trichloromethyl)-6-[2-(3,5-dimethoxyphenyl)ethenyl]-s-triazine, 2,4-bis(trichloromethyl)-6-[2-(3,5-diethoxyphenyl)ethenyl]-s-triazine, 2,4-bis(trichloromethyl)-6-[2-(3,5-dipropoxyphenyl)ethenyl]-s-triazine, 2,4-bis(trichloromethyl)-6-[2-(3-methoxy-5-ethoxyphenyl)ethenyl]-s-triazine, 2,4-bis(trichloromethyl)-6-[2-(3-methoxy-5-propoxyphenyl)ethenyl]-s-triazine, 2,4-bis(trichloromethyl)-6-[2-(3,4-methylenedioxyphenyl)ethenyl]-s-triazine, 2,4-bis(trichloromethyl)-6-(3,4-methylenedioxyphenyl)-s-triazine, 2,4-bis-trichloromethyl-6-(3-bromo-4-methoxy)phenyl-s-triazine, 2,4-bis-trichloromethyl-6-(2-bromo-4-methoxy)phenyl-s-triazine, 2,4-bistrichloromethyl-6-(2-bromo-4-methoxy)styrylphenyl-s-triazine, 2,4-bis-trichloromethyl-6-(3-bromo-4-methoxy)styrylphenyl-s-triazine, 2-(4-methoxyphenyl)-4,6-bis(trichloromethyl)-1,3,5-triazine, 2-(4-methoxynaphthyl)-4,6-bis(trichloromethyl)-1,3,5-triazine, 2-[2-(2-furyl)ethenyl]-4,6-bis(trichloromethyl)-1,3,5-triazine, 2-[2-(5-methyl-2-furyl)ethenyl]-4,6-bis(trichloromethyl)-1,3,5-triazine, 2-[2-(3,5-dimethoxyphenyl)ethenyl]-4,6-bis(trichloromethyl)-1,3,5-triazine, 2-[2-(3,4-dimethoxyphenyl)ethenyl]-4,6-bis(trichloromethyl)-1,3,5-triazine, 2-(3,4-methylenedioxyphenyl)-4,6-bis(trichloromethyl)-1,3,5-triazine, tris(1,3-dibromopropyl)-1,3,5-triazine, and tris(2,3-dibromopropyl)-1,3,5-triazine; and halogen-containing triazine compounds represented by the following formula (b3) such as tris(2,3-dibromopropyl)isocyanurate.

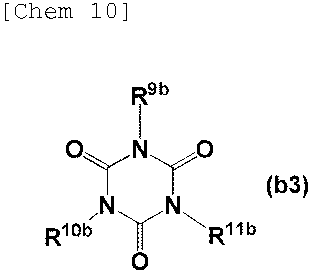

In the above formula (b3), R^{9b}, R^{10b}, and R^{11b} each independently represents a halogenated alkyl group.

### (Third acid generator)

The third acid generator includes α-(p-toluenesulfonyloxyimino)-phenylacetonitrile, α-(benzenesulfonyloxyimino)-2,4-dichlorophenylacetonitrile, α-(benzenesulfonyloxyimino)-2,6-dichlorophenylacetonitrile, α-(2-chlorobenzenesulfonyloxyimino)-4-methoxyphenylacetonitrile, and α-(ethylsulfonyloxyimino)-1-cyclopentenylacetonitrile and compounds represented by the following formula (b4) containing an oximesulfonate group.

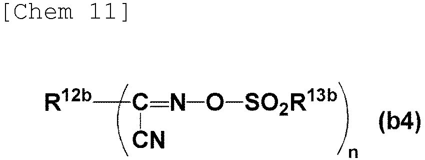

In the above formula (b4), R^{12b} represents a monovalent, divalent, or trivalent organic group, R^{13b} represents a substituted or unsubstituted saturated hydrocarbon group, an unsaturated hydrocarbon group, or an aromatic group, and n represents the number of repeating units of the structure in the parentheses.

In the above formula (b4), examples of the aromatic group include aryl groups such as a phenyl group and a naphthyl group and heteroaryl groups such as a furyl group and a thienyl group. These groups may have one or more appropriate substituents such as a halogen atom, an alkyl group, an alkoxy group and a nitro group on the rings. Furthermore, R^{13b} is particularly preferably an alkyl group having 1 or more and 6 or less carbon atoms, and examples thereof include a methyl group, an ethyl group, a propyl group and a butyl group. In particular, compounds in which R^{12b} is an aromatic group and in which and R^{13b} is an alkyl group having 1 or more and 4 or less carbon atoms are preferable.

Examples of the acid generator represented by the above formula (b4) include compounds in which R^{12b} is any one of a phenyl group, a methylphenyl group and a methoxyphenyl group, and R^{13b} is a methyl group when n=1, and specific examples thereof include α-(methylsulfonyloxyimino)-1-phenylacetonitrile, α-(methylsulfonyloxyimino)-1-(p-methylphenyl)acetonitrile, α-(methylsulfonyloxyimino)-1-(p-methoxyphenyl)acetonitrile, [2-(propylsulfonyloxyimino)-2,3-dihydroxythiophene-3-ylidene](o-tolyl)acetonitrile, and the like. Specifically, when n = 2, the acid generator represented by the above formula (b4) is an acid generator represented by the following formulae.

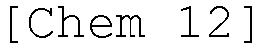

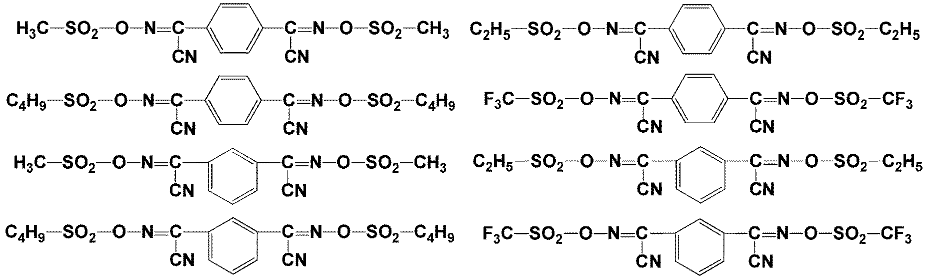

### (Fourth acid generator)

The fourth acid generator includes bissulfonyldiazomethanes such as bis(p-toluenesulfonyl)diazomethane, bis(1,1-dimethyl ethylsulfonyl)diazomethane, bis(cyclohexylsulfonyl)diazomethane, and bis(2,4-dimethylphenylsulfonyl)diazomethane; nitrobenzyl derivatives such as 2-nitrobenzyl p-toluenesulfonate, 2,6-dinitrobenzyl p-toluenesulfonate, nitrobenzyl tosylate, dinitrobenzyl tosylate, nitrobenzyl sulfonate, nitrobenzyl carbonate, and dinitrobenzyl carbonate; sulfonates such as pyrogalloltrimesylate, pyrogalloltritosylate, benzyltosylate, benzylsulfonate, N-methylsulfonyloxy succinimide, N-trichloromethylsulfonyloxy succinimide, N-phenylsulfonyloxy maleimide, and N-methylsulfonyloxy phthalimide; trifluoromethane sulfonates such as N-(trifluoromethylsulfonyloxy)phthalimide, N-(trifluoromethylsulfonyloxy)-1,8-naphthalimide, N-(trifluoromethylsulfonyloxy)-4-butyl-1,8-naphthalimide; onium salts such as diphenyliodonium hexafluorophosphate, (4-methoxyphenyl)phenyliodonium trifluoromethanesulfonate, bis(p-tert-butylphenyl)iodonium trifluoromethanesulfonate, triphenylsulfonium hexafluorophosphate, (4-methoxyphenyl)diphenylsulfonium trifluoromethanesulfonate, and (p-tert-butylphenyl)diphenylsulfonium trifluoromethanesulfonate, etc.; benzointosylates such as benzointosylate and α-methylbenzointosylate; other diphenyliodonium salts, triphenylsulfonium salts, phenyldiazonium salts, benzylcarbonates; and the like.

The acid generators (A) may be used alone, or two or more types may be used in combination. Furthermore, the content of the acid generator (A) is preferably 0.1 part by mass or more and 30 parts by mass or less, and particularly preferably 1 part by mass or more and 20 parts by mass or less with respect to 100 parts by mass of the novolak resin contained in the chemically amplified positive-type photosensitive resin composition. When the amount of acid generator (A) used is set within the range described above, it is easy to prepare the photosensitive resin composition having excellent sensitivity, being a uniform solution, and having excellent storage stability.

The chemically amplified positive-type photosensitive resin composition contains a (S) solvent for the purpose of, for example, adjusting the coating characteristics. The type of the solvent (S) is not particularly limited within a range where the objects of the present invention are not impaired and can be appropriately selected from solvents used for a positive-type photosensitive resin composition.

Specific examples of the solvent (S) includes: ketones such as acetone, methyl ethyl ketone, cyclohexanone, methyl isoamyl ketone, and 2-heptanone; glycols such as ethylene glycol, diethylene glycol, triethylene glycol, propylene glycol, dipropylene glycol, tripropylene glycol, 1,3-butylene glycol, hexylene glycol; polyols such as glycerine; monools such as benzyl alcohol, and terpineol; glycol monoacetates such as ethylene glycol monoacetate, diethylene glycol monoacetate, triethylene glycol monoacetate, propylene glycol monoacetate, dipropylene glycol monoacetate, tripropylene glycol monoacetate, and 1,3-butylene glycol monoacetate; glycol diacetates such as ethylene glycol diacetate, diethylene glycol diacetate, triethylene glycol diacetate, propylene glycol diacetate, dipropylene glycol diacetate, tripropylene glycol diacetate, and 1,3-butylene glycol diacetate; glycol monoethers such as ethylene glycol monomethyl ether, ethylene glycol monoethyl ether, ethylene glycol monopropyl ether, ethylene glycol monobutyl ether, ethylene glycol monophenyl ether, diethylene glycol monomethyl ether, diethylene glycol monoethyl ether, diethylene glycol monopropyl ether, diethylene glycol monobutyl ether, diethylene glycol monophenyl ether, triethylene glycol monomethyl ether, triethylene glycol monoethyl ether, triethylene glycol monopropyl ether, triethylene glycol monobutyl ether, triethylene glycol monophenyl ether, propylene glycol monomethyl ether, propylene glycol monoethyl ether, propylene glycol monopropyl ether, propylene glycol monobutyl ether, propylene glycol monophenyl ether, dipropylene glycol monomethyl ether, dipropylene glycol monoethyl ether, dipropylene glycol monopropyl ether, dipropylene glycol monobutyl ether, dipropylene glycol monophenyl ether, tripropylene glycol monomethyl ether, tripropylene glycol monoethyl ether, tripropylene glycol monopropyl ether, tripropylene glycol monobutyl ether, tripropylene glycol monophenyl ether, 1,3-butylene glycol monomethyl ether, 1,3-butylene glycol monoethyl ether, 1,3-butylene glycol monopropyl ether, 1,3-butylene glycolmonobutyl ether, and 1,3-butylene glycol monophenyl ether; glycol monoether acetates such as ethylene glycol monomethyl ether acetate, ethylene glycol monoethyl ether acetate, ethylene glycol monopropyl ether acetate, ethylene glycol monobutyl ether acetate, ethylene glycol monophenyl ether acetate, diethylene glycol monomethyl ether acetate, diethylene glycol monoethyl ether acetate, diethylene glycol monopropyl ether acetate, diethylene glycol monobutyl ether acetate, diethylene glycol monophenyl ether acetate, triethylene glycol monomethyl ether acetate, triethylene glycol monoethyl ether acetate, triethylene glycol monopropyl ether acetate, triethylene glycol monobutyl ether acetate, triethylene glycol monophenyl ether acetate, propylene glycol monomethyl ether acetate, propylene glycol monoethyl ether acetate, propylene glycol monopropyl ether acetate, propylene glycol monobutyl ether acetate, propylene glycol monophenyl ether acetate, dipropylene glycol monomethyl ether acetate, dipropylene glycol monoethyl ether acetate, dipropylene glycol monopropyl ether acetate, dipropylene glycol monobutyl ether acetate, dipropylene glycol monophenyl ether acetate, tripropylene glycol monomethyl ether acetate, tripropylene glycol monoethyl ether acetate, tripropylene glycol monopropyl ether acetate, tripropylene glycol monobutyl ether acetate, tripropylene glycol monophenyl ether acetate, 1,3-butylene glycol monomethyl ether acetate(3-methoxybutyl acetate), 1,3-butylene glycolmonoethyl ether acetate, 1,3-butylene glycolmonopropyl ether acetate, 1,3-butylene glycolmonobutyl ether acetate, 1,3-butylene glycolmonophenyl ether acetate, 3-methyl-3-methoxybutyl acetate, 3-ethyl-3-methoxybutyl acetate, 2-methoxy pentyl acetate, 3-methoxy pentyl acetate, 4-methoxy pentyl acetate, 2-methyl-3-methoxy pentyl acetate, 3-methyl-3-methoxy pentyl acetate, 3-methyl-4-methoxy pentyl acetate, and 4-methyl-4-methoxy pentyl acetate; glycol diethers such as ethylene glycol dimethyl ether, ethylene glycol diethyl ether, ethylene glycol dipropyl ether, ethylene glycol dibutyl ether, ethylene glycol diphenyl ether, diethylene glycol dimethyl ether, diethylene glycol diethyl ether, diethylene glycol dipropyl ether, diethylene glycol dibutyl ether, diethylene glycol diphenyl ether, triethylene glycol dimethyl ether, triethylene glycol diethyl ether, triethylene glycol dipropyl ether, triethylene glycol dibutyl ether, triethylene glycol diphenyl ether, propylene glycol dimethyl ether, propylene glycol diethyl ether, propylene glycol dipropyl ether, propylene glycol dibutyl ether, propylene glycol diphenyl ether, dipropylene glycol dimethyl ether, dipropylene glycol diethyl ether, dipropylene glycol dipropyl ether, dipropylene glycol dibutyl ether, dipropylene glycol diphenyl ether, tripropylene glycol dimethyl ether, tripropylene glycol diethyl ether, tripropylene glycol dipropyl ether, tripropylene glycol dibutyl ether, tripropylene glycol diphenyl ether, 1,3-butylene glycol dimethyl ether, 1,3-butylene glycol diethyl ether, 1,3-butylene glycoldipropyl ether, 1,3-butylene glycoldibutyl ether, and 1,3-butylene glycol diphenyl ether; ethers such as dioxane and dihexyl ether; esters such as methyl formate, methyl lactate, ethyl lactate, methyl acetate, ethyl acetate, butyl acetate, benzyl acetate, ethyl benzoate, methyl pyruvate, methyl acetoacetate, ethyl acetoacetate, ethyl pyruvate, ethyl ethoxyacetate, methyl methoxypropionate, ethyl ethoxypropionate, 2-hydroxy methyl propionate, 2-hydroxy ethyl propionate, 2-hydroxy-2-methyl ethyl propionate, 2-hydroxy-3-methylbutanoic acid methyl, diethyl maleate, cyclohexanol acetate, and gamma butyrolactone; aromatic hydrocarbons such as toluene and xylene, and the like. These may be used alone, or two or more types may be used in mixture.

The chemically amplified positive-type photosensitive resin composition preferably includes a high boiling-point solvent (S1) having a boiling point of 170°C or more in the atmospheric pressure. From the viewpoint of satisfactory solubility of each component included in the chemically amplified positive-type photosensitive resin composition and easiness of availability, and the like, preferable examples of the high boiling point solvents (S1) in the specific examples of the solvent (S) mentioned above include ethylene glycol, diethylene glycol, dipropylene glycol, hexylene glycol, glycerin, benzyl alcohol, terpineol, propylene glycol diacetate, 1,3-butylene glycol diacetate, diethylene glycol monomethyl ether, diethylene glycol monoethyl ether, diethylene glycol monopropyl ether, diethylene glycol monobutyl ether, diethylene glycol monophenyl ether, dipropylene glycol monomethyl ether, tripropylene glycol monomethyl ether, ethylene glycol monobutyl ether acetate, ethylene glycol monophenyl ether acetate, diethylene glycol monomethyl ether acetate, diethylene glycol monoethyl ether acetate, diethylene glycol monopropyl ether acetate, diethylene glycol monobutyl ether acetate, diethylene glycol monophenyl ether acetate, dipropylene glycol monomethyl ether acetate, 1,3-butylene glycol monomethyl ether acetate(3-methoxybutyl acetate), 3 methyl-3-methoxybutyl acetate, 3-ethyl-3-methoxybutyl acetate, 2-methoxypentyl acetate, 3-methoxypentyl acetate, 4-methoxypentyl acetate, 2-methyl-3-methoxypentyl acetate, 3-methyl-3-methoxypentyl acetate, 3-methyl-4-methoxypentyl acetate, and 4-methyl-4-methoxypentyl acetate, diethylene glycol diethyl ether, dipropylene glycol dimethyl ether, dihexyl ether benzyl acetate, ethyl benzoate, diethyl maleate, cyclohexanol acetate, gamma-butyrolactone, and the like.

The content of the high boiling-point solvent (S1) in the chemically amplified positive-type photosensitive resin composition is not particularly limited as long as a desired effect by the use of the high boiling-point solvent (S1) is obtained. The content of the high boiling-point solvent (S1) in the chemically amplified positive-type photosensitive resin composition is, from the viewpoint of the coating characteristics, preferably 1 part by mass or more and less than 50 parts by mass, and more preferably 1 part by mass or more and 20 parts by mass or less when the total mass of the solvent (S) in the chemically amplified positive-type photosensitive resin composition is 100 parts by mass. Furthermore, the content of the high boiling-point solvent (S1) is preferably 0.5% by mass or more and 20% by mass or less, more preferably 1% by mass or more and 15% by mass or less, and particularly preferably 2% by mass or more and 10% by mass or less with respect to the total mass of the chemically amplified positive-type photosensitive resin composition.

The content of the solvent (S) in the chemically amplified positive-type photosensitive resin composition is not particularly limited as long as a patterned cured product (mask) having a desired film thickness can be formed. The solvent (S) is used, for example, in an amount such that the solid component concentration (solid content concentration) of the chemically amplified positive-type photosensitive resin composition is preferably 40% by mass or more and 70% by mass or less, and more preferably 45% by mass or more and 65% by mass or less from the viewpoint of manufacturing steps such as a margin in the etching processing.

A chemically amplified negative-type photosensitive resin composition typically comprises a crosslinking agent, an acid generator as a photosensitizer (B), and a novolak resin. In such a chemically amplified negative-type photosensitive resin composition, the novolak resin can be crosslinked with a crosslinking agent by the action of an acid generated from the acid generator by exposure.

In the chemically amplified negative-type photosensitive resin composition, a novolak resin in an unprotected state before the phenolic hydroxy group is protected by the acid-dissociable dissolution-inhibiting group exemplified for the chemically amplified positive-type photosensitive resin composition can be used as the novolak resin.

The content of the novolak resin contained in the chemically amplified negative-type photosensitive resin composition is preferably 50% by mass or more and 99% by mass or less, more preferably 55% by mass or more and 95% by mass or less, with respect to the mass of the solid content of the chemically amplified negative-type photosensitive resin composition. The above range tends to provide well-balanced developability.

As an acid generator contained in the chemically amplified negative-type photosensitive resin composition, the acid generators exemplified for the chemically amplified positive-type photosensitive resin composition can be used.

The content of the acid generator is preferably 0.1 part by mass or more and 30 parts by mass or less, particularly preferably 0.3 parts by mass or more and 20 parts by mass or less, with respect to 100 parts by mass of the novolak resin contained in the chemically amplified negative-type photosensitive resin composition. When the used amount of the acid generator is within the above range, it is easy to prepare a chemically amplified negative-type photosensitive resin composition which has good sensitivity, which is a uniform solution, and which is excellent in storage stability.

The crosslinking agent contained in the chemically amplified negative-type photosensitive resin composition is not particularly limited, and an amino compound such as melamine resins, urea resins, guanamine resins, glycoluryl-formaldehyde resins, succinylamide-formaldehyde resins, ethylene urea-formaldehyde resins, etc. can be used.

Of these, alkoxymethylated amino resins such as alkoxymethylated melamine resins and alkoxymethylated urea resins are preferred. The alkoxymethylated amino resin can be produced, for example, by reacting melamine or urea with formalin in a boiling aqueous solution to obtain a condensate, etherifying the condensate with a lower alcohol such as methyl alcohol, ethyl alcohol, propyl alcohol, butyl alcohol, isopropyl alcohol, and the like, and cooling the reaction solution to deposit the alkoxymethylated amino resin. Examples of the alkoxymethylated amino resin include methoxymethylated melamine resins, ethoxymethylated melamine resins, propoxymethylated melamine resins, butoxymethylated melamine resins, methoxymethylated urea resins, ethoxymethylated urea resins, propoxymethylated urea resins, butoxymethylated urea resins, etc. These crosslinking agents may be used alone or in combination of two or more types.

The content of the crosslinking agent is preferably 5 parts by mass or more and 50 parts by mass or less, more preferably 7 parts by mass or more and 30 parts by mass or less, with respect to 100 parts by mass of the novolak resin contained in the chemically amplified negative-type photosensitive resin composition. When the content is within the above range, chemically amplified negative-type photosensitive resin composition curing characteristics and patterning properties are good.

As the solvent (S) contained in the chemically amplified negative-type photosensitive resin composition, the solvents exemplified for the chemically amplified positive-type photosensitive resin composition can be used.

The content of the high boiling point solvent (S1) in the chemically amplified negative-type photosensitive resin composition is not particularly limited, as long as a desired effect due to the use of the high boiling point solvent (S1) can be obtained. The content of the high boiling point solvent (S1) in the chemically amplified negative-type photosensitive resin composition is preferably 1 part by mass or more and less than 50 parts by mass, and more preferably 1 part by mass or more and 20 parts by mass or less, from the viewpoint of coatability, when the total mass of the solvent (S) in the chemically amplified negative-type photosensitive resin composition is set to 100 parts by mass. Further, the content of the high boiling point solvent (S1) is preferably 0.5% by mass or more and 20% by mass or less, more preferably 1% by mass or more and 15% by mass or less, and particularly preferably 2% by mass or more and 10% by mass or less, with respect to the total mass of the chemically amplified negative-type photosensitive resin composition.

The content of the solvent (S) in the chemically amplified negative-type photosensitive resin composition is not particularly limited, as long as the chemically amplified negative-type photosensitive resin composition can form a patterned cured product (protective film) having a desired film thickness. The solvent (S) is used, for example, in an amount such that the solid component concentration of the chemically amplified negative-type photosensitive resin composition is preferably 40% by mass or more and 70% by mass or less, and, more preferably 45% by mass or more and 65% by mass or less from the viewpoint of manufacturing steps such as a margin, etc. in the etching processing.

A non-chemically amplified positive-type photosensitive resin composition (hereinafter, also referred to as "NQD positive-type photosensitive resin composition") typically includes a compound having a naphthoquinonediazide group as the photosensitizer (B) and an alkali-soluble novolak resin.

As the alkali-soluble novolak resin contained in the NQD positive-type photosensitive resin composition, a novolak resin in an unprotected state before the phenolic hydroxy group is protected by the acid-dissociable dissolution-inhibiting group exemplified for the chemically amplified positive-type photosensitive resin composition can be used.

The content of the alkali-soluble novolak resin contained in the NQD positive-type photosensitive resin composition is preferably 30% by mass or more and 99% by mass or less, and more preferably 40% by mass or more and 95% by mass or less, with respect to the solid content of the NQD positive-type photosensitive resin composition. The above range tends to provide well-balanced developability.

The compound having a naphthoquinonediazide group contained in the NQD positive-type photosensitive resin composition is not particularly limited, but a fully esterified product or a partially esterified product of a compound having one or more phenolic hydroxy groups and a naphthoquinonediazide group-containing sulfonic acid is preferred. Such a naphthoquinonediazide group-containing compound can be obtained by condensing a compound having one or more phenolic hydroxy groups and a naphthoquinonediazide group-containing sulfonic acid in the presence of an alkali such as triethanolamine, alkali carbonate, or alkali hydrogencarbonate in a suitable solvent such as dioxane, to fully esterify or partially esterify.

Examples of the compound having one or more phenolic hydroxy group include: polyhydroxybenzophenones such as 2,3,4-trihydroxybenzophenone and 2,3,4,4'-tetrahydroxybenzophenone; trisphenol type compounds such as tris(4-hydroxyphenyl)methane, bis(4-hydroxy-3-methylphenyl)-2-hydroxyphenylmethane, bis(4-hydroxy-2,3,5-trimethylphenyl)-2-hydroxyphenylmethane, bis(4-hydroxy-3,5-dimethylphenyl)-4-hydroxyphenylmethane, bis(4-hydroxy-3,5-dimethylphenyl)-3-hydroxyphenylmethane, bis(4-hydroxy-3,5-dimethylphenyl)-2-hydroxyphenylmethane, bis(4-hydroxy-2,5-dimethylphenyl)-4-hydroxyphenylmethane, bis(4-hydroxy-2,5-dimethylphenyl)-3-hydroxyphenylmethane, bis(4-hydroxy-2,5-dimethylphenyl)-2-hydroxyphenylmethane, bis(4-hydroxy-3,5-dimethylphenyl)-3,4-dihydroxyphenylmethane, bis(4-hydroxy-2,5-dimethylphenyl)-3,4-dihydroxyphenylmethane, bis(4-hydroxy-2,5-dimethylphenyl)-2,4-dihydroxyphenylmethane, bis(4-hydroxyphenyl)-3-methoxy-4-hydroxyphenylmethane, bis(5-cyclohexyl-4-hydroxy-2-methylphenyl)-4-hydroxyphenylmethane, bis(5-cyclohexyl-4-hydroxy-2-methylphenyl)-3-hydroxyphenylmethane, bis(5-cyclohexyl-4-hydroxy-2-methylphenyl)-2-hydroxyphenylmethane, bis(5-cyclohexyl-4-hydroxy-2-methylphenyl)-3,4-dihydroxyphenylmethane, etc.; linear trinuclear phenol compounds such as 2,4-bis(3,5-dimethyl-4-hydroxybenzyl)-5-hydroxyphenol, 2,6-bis(2,5-dimethyl-4-hydroxybenzyl)-4-methylphenol, etc.; linear tetranuclear phenol compounds such as 1,1-bis[3-(2-hydroxy-5-methylbenzyl)-4-hydroxy-5-cyclohexylphenyl]isopropane, bis[2,5-dimethyl-3-(4-hydroxy-5-methylbenzyl)-4-hydroxyphenyl]methane, bis[2,5-dimethyl-3-(4-hydroxybenzyl)-4-hydroxyphenyl]methane, bis[3-(3,5-dimethyl-4-hydroxybenzyl)-4-hydroxy-5-methylphenyl]methane, bis[3-(3,5-dimethyl-4-hydroxybenzyl)-4-hydroxy-5-ethylphenyl]methane, bis[3-(3,5-diethyl-4-hydroxybenzyl)-4-hydroxy-5-methylphenyl]methane, bis[3-(3,5-diethyl-4-hydroxybenzyl)-4-hydroxy-5-ethylphenyl]methane, bis[2-hydroxy-3-(3,5-dimethyl-4-hydroxybenzyl)-5-methylphenyl]methane, bis[2-hydroxy-3-(2-hydroxy-5-methylbenzyl)-5-methylphenyl]methane, bis[4-hydroxy-3-(2-hydroxy-5-methylbenzyl)-5-methylphenyl]methane, bis[2,5-dimethyl-3-(2-hydroxy-5-methylbenzyl)-4-hydroxyphenyl]methane, etc.; linear pentanuclear phenol compounds such as 2,4-bis[2-hydroxy-3-(4-hydroxybenzyl)-5-methylbenzyl]-6-cyclohexylphenol, 2,4-bis[4-hydroxy-3-(4-hydroxybenzyl)-5-methylbenzyl]-6-cyclohexylphenol, 2,6-bis[2,5-dimethyl-3-(2-hydroxy-5-methylbenzyl)-4-hydroxybenzyl]-4-methylphenol, etc.; bisphenol type compounds such as bis(2,3,4-trihydroxyphenyl)methane, bis(2,4-dihydroxyphenyl)methane, 2,3,4-trihydroxyphenyl-4'-hydroxyphenylmethane, 2-(2,3,4-trihydroxyphenyl)-2-(2',3',4'-trihydroxyphenyl)propane, 2-(2,4-dihydroxyphenyl)-2-(2',4'-dihydroxyphenyl)propane, 2-(4-hydroxyphenyl)-2-(4'-hydroxyphenyl)propane, 2-(3-fluoro-4-hydroxyphenyl)-2-(3'-fluoro-4'-hydroxyphenyl)propane, 2-(2,4-dihydroxyphenyl)-2-(4'-hydroxyphenyl)propane, 2-(2,3,4-trihydroxyphenyl)-2-(4'-hydroxyphenyl)propane, 2-(2,3,4-trihydroxyphenyl)-2-(4'-hydroxy-3',5'-dimethylphenyl)propane, 4,4'-[1-[4-[1-(4-hydroxyphenyl)-1-methylethyl]phenyl]ethylidene]bisphenol, etc.; polynuclear branched compounds such as 1-[1-(4-hydroxyphenyl)isopropyl]-4-[1,1-bis(4-hydroxyphenyl)ethyl]benzene, 1-[1-(3-methyl-4-hydroxyphenyl)isopropyl]-4-[1,1-bis(3-methyl-4-hydroxyphenyl)ethyl]benzene, 4,4'-[1-[4-[1-[4-hydroxyphenyl]-1-methylethyl]phenyl]ethylidene]bisphenol, etc.; and condensed phenol compounds such as 1,1-bis(4-hydroxyphenyl)cyclohexane, etc.; and the like. These compounds may be used alone or in combination of two or more types.

Examples of the above-mentioned naphthoquinonediazide group containing sulfonic acid include naphthoquinone-1,2-diazido-5-sulfonic acid, naphthoquinone-1,2-diazido-4-sulfonic acid, orthoanthraquinonediazidosulfonic acid, etc.

The content of the compound having a naphthoquinonediazide group is preferably 5 parts by mass or more and 60 parts by mass or less, and more preferably 10 parts by mass or more and 50 parts by mass or less, with respect to 100 parts by mass of the alkali-soluble novolak resin contained in the NQD positive-type photosensitive resin composition. When the content is within the above range, curing properties and patterning characteristics of the NQD positive-type photosensitive resin composition are good.

As the solvent (S) contained in the NQD positive-type photosensitive resin composition, the solvents exemplified for the chemically amplified positive-type photosensitive resin composition can be used.

The content of the high boiling point solvent (S1) in the NQD positive-type photosensitive resin composition is not particularly limited, as long as a desired effect due to the use of the high boiling point solvent (S1) can be obtained. The content of the high boiling point solvent (S1) in the NQD positive-type photosensitive resin composition is preferably 1 part by mass or more and less than 50 parts by mass, and more preferably 1 part by mass or more and 20 parts by mass or less, from the viewpoint of coatability, when the total mass of the solvent (S) in the NQD positive-type photosensitive resin composition is set to 100 parts by mass. Further, the content of the high boiling point solvent (S1) is preferably 0.5% by mass or more and 20% by mass or less, more preferably 1% by mass or more and 15% by mass or less, and particularly preferably 2% by mass or more and 10% by mass or less, with respect to the total mass of the NQD positive-type photosensitive resin composition.

The content of the solvent (S) in the NQD positive-type photosensitive resin composition is not particularly limited, as long as a patterned cured product (protective film) having a desired film thickness can be formed. The solvent (S) is used, for example, in an amount such that the solid component concentration of the NQD positive-type photosensitive resin composition is preferably 40% by mass or more and 70% by mass or less. The solvent (S) is used, for example, in an amount such that the solid component concentration of the NQD positive-type photosensitive resin composition is preferably 45% by mass or more and 65% by mass or less from the viewpoint of manufacturing steps such as a margin, etc. in the etching processing.

It is preferable that photosensitive resin compositions (chemically amplified positive-type photosensitive resin composition, chemically amplified negative-type photosensitive resin composition, and NQD positive-type photosensitive resin composition) contain barium sulfate particles having an average particle diameter of 500 nm or less. When the photosensitive resin composition contains barium sulfate particles having an average particle diameter of 500 nm or less, resolution or etching resistance can be improved. The average particle diameter of the barium sulfate particles is, for example, 10 nm or more. The average particle diameter (volume average diameter) of barium sulfate particles in the photosensitive resin composition can be determined by measuring using a dynamic light scattering type nanotrack particle size distribution meter and calculating the volume average diameter. Further, the average particle diameter (volume average diameter) of the barium sulfate particles to be used can be determined by measuring the particle diameter of each particle by, for example, a transmission electron microscope or a scanning electron microscope, and calculating the volume average diameter.

The average particle diameter of the barium sulfate particles is preferably 5 nm or more and 500 nm or less, more preferably 10 nm or more and 300 nm or less, more preferably 15 nm or more and 200 nm or less, and particularly preferably 15 nm or more and 60 nm or less. When the photosensitive resin composition contains barium sulfate particles having an average particle diameter of 5 nm or more and 500 nm or less, it is possible to improve resolution and suppress an adverse effect on the noble metal catalyst while maintaining the effect to improve the etching resistance of the patterned cured product (mask) to be formed. Further, when the photosensitive resin composition contains barium sulfate particles having an average particle diameter of 200 nm or less, the pattern shape is good.

The content of the barium sulfate particles is preferably 30 parts by mass or more and 70 parts by mass or less, and more preferably 35 parts by mass or more and 60 parts by mass or less, with respect to 100 parts by mass of the novolak resin.

The photosensitive resin composition (chemically amplified positive-type photosensitive resin composition, chemically amplified negative-type photosensitive resin composition, and NQD positive-type photosensitive resin composition) contains a plasticizer. Since the photosensitive resin composition contains a plasticizer, occurrence of cracks in the patterned cured product (mask) formed using the photosensitive resin composition can be suppressed.

The polyvinyl alkyl ether is selected because it is easy to form a mask excellent in resistance to an etchant.

With regard to the alkyl portion of the polyvinyl alkyl ether, the number of carbon atoms thereof is preferably 1 or more and 5 or less, and more preferably 1 or 2. In other words, as the polyvinyl alkyl ethers, polyvinyl methyl ether and polyvinyl ethyl ether are more preferred.

The mass average molecular weight of the polyvinyl alkyl ethers is not particularly limited. The mass average molecular weight of the polyvinyl alkyl ethers is preferably 10,000 or more and 200,000 or less, and more preferably 50,000 or more and 100,000 or less.

The content of a plasticizer in the photosensitive resin composition is not particularly limited, as long as a desired effect can be obtained by using the plasticizer. The content of a plasticizer in the photosensitive resin composition is 5 parts by mass or more and 100 parts by mass or less, preferably 10 parts by mass or more and 80 parts by mass or less, and most preferably 15 parts by mass or more and 60 parts by mass or less, with respect to 100 parts by mass of the novolak resin.

The photosensitive resin composition may include various components that have conventionally been blended in photosensitive resin compositions.

For example, the photosensitive resin composition may further contain a surfactant for improving coating, defoaming, leveling, and the like. As the surfactant, for example, a fluorinated surfactant and a silicone surfactant are preferably used. Specific examples of the fluorinated surfactant include commercially available fluorochemical surfactants such as BM-1000 and BM-1100 (both manufactured by BM Chemie GmbH), Megafac F142D, Megafac F172, Megafac F173 and Megafac F183 (all manufactured by DIC Corporation), Flolade FC-135, Flolade FC-170C, Flolade FC-430 and Flolade FC-431 (all manufactured by Sumitomo 3M Ltd.), Surflon S-112, Surflon S-113, Surflon S-131, Surflon S-141 and Surflon S-145 (all manufactured by AGC Inc.), SH-28PA, SH-190, SH-193, SZ-6032 and SF-8428 (all manufactured by Toray Silicone Co., Ltd.), but there is no limitation to those. As the silicone surfactant, a non-modified silicone surfactant, a polyether modified silicone surfactant, a polyester modified silicone surfactant, an alkyl modified silicone surfactant, an aralkyl modified silicone surfactant, a reactive silicone surfactant and the like can be preferably used. As the silicone surfactant, a commercially available silicone surfactant can be used. Specific examples of the commercially available silicone surfactant include Paintad M (manufactured by Dow Corning Toray Co., Ltd.), TOPICA K1000, TOPICA K2000 and TOPICA K5000 (all of which are manufactured by Takachiho Sangyo Co., Ltd.), XL-121 (polyether modified silicone surfactant, manufactured by Clariant), BYK-088 (silicone defoaming agent, manufactured by BYK-Chemie GmbH) (BYK-310 (polyester modified silicone surfactant, manufactured by BYK-Chemie GmbH), and the like.

Furthermore, in order to finely adjust the solubility in a developing solution, the photosensitive resin composition may further contain an acid, or an acid anhydride.

Specific examples of the acid and acid anhydride can include monocarboxylic acids such as acetic acid, propionic acid, n-butyric acid, isobutyric acid, n-valeric acid, isovaleric acid, benzoic acid, and cinnamic acid; hydroxymonocarboxylic acids such as lactic acid, 2-hydroxybutyric acid, 3-hydroxybutyric acid, salicylic acid, m-hydroxybenzoic acid, p-hydroxybenzoic acid, 2-hydroxycinnamic acid, 3-hydroxycinnamic acid, 4-hydroxycinnamic acid, 5-hydroxyisophthalic acid, and syringic acid; polyvalent carboxylic acids such as oxalic acid, succinic acid, glutaric acid, adipic acid, maleic acid, itaconic acid, hexahydrophthalic acid, phthalic acid, isophthalic acid, terephthalic acid, 1,2-cyclohexanedicarboxylic acid, 1,2,4-cyclohexanetricarboxylic acid, butanetetracarboxylic acid, trimellitic acid, pyromellitic acid, cyclopentanetetracarboxylic acid, butanetetracarboxylic acid, and 1,2,5,8-naphthalenetetracarboxylic acid; acid anhydrides such as itaconic anhydride, succinic anhydride, citraconic anhydride, dodecenylsuccinic anhydride, tricarbanilic anhydride, maleic anhydride, hexahydrophthalic anhydride, methyltetrahydrophthalic anhydride, Himic anhydride, 1,2,3,4-butanetetracarboxylic acid, cyclopentanetetracarboxylic dianhydride, phthalic anhydride, pyromellitic anhydride, trimellitic anhydride, benzophenonetetracarboxylic anhydride, ethylene glycol bis anhydrous trimellitate, and glycerin tris anhydrous trimellitate; and the like.

Note that the above-described components are uniformly mixed in a desired ratio to obtain a photosensitive resin composition.

### (Coating method)

A method for coating a substate 1 with a photosensitive resin composition is not particularly limited. A photosensitive resin composition can be applied using, for example, a contact transfer type coating device such as a roll coater, a reverse coater, or a bar coater, or a non-contact type coating device such as a spinner, a curtain flow coater, or a slit coater. The formed coating film may be heated (prebaked) as necessary.

Although the conditions for the pre-baking differ depending on the types of components in the photosensitive resin composition, the mixing ratio, the thickness of the coating film and the like, the pre-baking is performed normally at 70°C or more and 200°C or less and preferably at 80°C or more and 150°C or less for about 2 minutes or more and 120 minutes or less. For example, the photosensitive resin composition may be heated at a temperature less than 100°C and then may be further heated at a temperature of 100°C or more.

### <Exposure step>

In the exposure step, a coating film is exposed in a position-selective manner. The position-selective exposure is performed depending upon the position and shape of through-holes or through-grooves to be formed. Specifically, a coating film is position-selectively irradiated with (exposed to) an active ray or radiation, for example, ultraviolet radiation or visible light with a wavelength of 300 nm or more and 500 nm or less through a mask having a predetermined pattern.

Low pressure mercury lamps, high pressure mercury lamps, super high pressure mercury lamps, metal halide lamps, argon gas lasers, etc. can be used as a radiation source. The radiation may include micro waves, infrared rays, visible light, ultraviolet rays, X-rays, γ-rays, electron beams, proton beams, neutron beams, ion beams, and the like. The irradiation dose of the radiation may vary depending on the constituent of the photosensitive resin composition, the film thickness of the coating layer, and the like. For example, when a super high pressure mercury lamp is used, the dose may be 100 mJ/cm² or more and 10,000 mJ/cm² or less.

When the chemically amplified photosensitive resin composition is used, after exposure and before development, the coating film may be heated using a known method. By heating the coating film to promote diffusion of acid, it is possible to change the solubility of the coating film to a developing solution at the exposed portion in the coating film. The heating conditions after exposure and before development vary depending on the type of each component in the photosensitive resin composition, the blending ratio, the coating film thickness, and the like, but are, for example, 90°C or more and 150°C or less and about 2 minutes or more and 120 minutes or less.

### <Developing step>

By developing a coating film after exposure, a part of the substrate 1 is exposed and a patterned cured product is obtained. Thereby, as shown in Fig. 1A, a patterned cured product as a mask (protective film) 3 for etching is formed on the substrate 1. The thickness of the patterned cured product is preferably 25 um or more.

As the developing solution, an aqueous solution of an alkali such as, for example, sodium hydroxide, potassium hydroxide, sodium carbonate, sodium silicate, sodium metasilicate, aqueous ammonia, ethylamine, n-propylamine, diethylamine, di-n-propylamine, triethylamine, methyldiethylamine, dimethylethanolamine, triethanolamine, tetramethylammonium hydroxide, tetraethylammonium hydroxide, pyrrole, piperidine, 1,8-diazabicyclo[5,4,0]-7-undecene, and 1,5-diazabicyclo[4,3,0]-5-nonane can be used. Also, an aqueous solution prepared by adding an adequate amount of a watersoluble organic solvent such as methanol or ethanol or a surfactant to the aqueous solution of the alkali can be used as the developing solution.

The developing time may vary depending on the composition of the photosensitive resin composition, the film thickness of the coating film, and the like. Usually, the developing time is 1 minute or more and 30 minutes or less. The developing method may be any one of a liquid-filling method, a dipping method, a paddle method, a spray developing method, and the like.

By using the above-described photosensitive resin composition, it is possible to suppress components contained in the photosensitive resin composition from remaining in a region 4 after the developing step, on which a noble metal catalyst 5 is to be supported.

After development, washing with running water for 30 seconds or more and 90 seconds or less and drying with an air gun, an oven, and the like are carried out as necessary.

### <Post-baking step>

The etching method of the present invention may have a post-baking step of heating the patterned cured product after development. When a negative-type photosensitive resin composition is used, the post-baking temperature is, for example, 120°C or more, and may be 200°C or more, but is preferably 180°C or less. When the positive-type photosensitive resin composition is used, the post-baking temperature is, for example, 90°C or more, and is preferably 100°C or more and 150°C or less. The post-baking time is, for example, about 2 minutes or more and 120 minutes or less. In addition, the post-baking step may be a stepwise heating (step baking). For example, after a first stage heating at 180°C or less for 1 minute or more and 60 minutes or less, a second stage heating at a temperature higher than the heating temperature in the first stage for 1 minute or more and 60 minutes or less may be performed.

### <Noble metal catalyst supporting step>

In the noble metal catalyst supporting step, the region 4 where the substrate 1 is exposed, is made to support the noble metal catalyst 5 after the developing step and before the etching step, as shown in Fig. 1B. Note that when the post-baking step is performed after the developing step, the noble metal catalyst supporting step is performed after the post-baking step and before the etching step.

Examples of the noble metal catalyst 5 include layered, particulate, plate-like, and rod-like noble metals. Examples of the noble metal include Au, Ag, Pt, Pd, Ru and Rh. In a case of a layered noble metal, the thickness of the noble metal layer is preferably 0.001 um or more and 1 um or less. Note that the thickness of the noble metal layer can be determined by a transmission electron microscope or a scanning electron microscope.

Examples of a method for making the region 4 where the substrate 1 is exposed support the noble metal catalyst 5 include substitution plating, electroplating, reduction plating, coating of a dispersion containing a noble metal, and a vapor phase deposition method such as vapor deposition and a sputtering method.

By using the above-described photosensitive resin composition, the region 4 formed by the photosensitive resin composition can satisfactorily support the noble metal catalyst 5.

### <Etching step>

In the etching step, a hole or groove 6 is formed in the substrate 1 by etching the substrate 1 in the presence of a noble metal catalyst using a patterned cured product as a mask 3 and an aqueous solution containing a corrosive agent and an oxidizing agent as the etchant.

### (Etchant)

The etchant is an aqueous solution containing a corrosive agent and an oxidizing agent. The corrosive agent dissolves an oxide produced by the oxidizing agent. Examples of the corrosive agent include hydrogen fluoride. Note that hydrogen fluoride dissolves in water, and thus is present as hydrofluoric acid in the etchant. Examples of the oxidizing agent include hydrogen peroxide, nitric acid, AgNO₃, KAuCl₄, HAuCl₄, K₂PtCl₆, H₂PtCl₆, Fe(NO₃)₃, Ni(NO₃)₂, Mg(NO₃)₂, Na₂S₂O₈, K₂S₂O₈, KMnO₄, and K₂Cr₂O₇, and hydrogen peroxide and nitric acid are preferred.

The concentration of the corrosive agent in the etchant is preferably 1% by mass or more and 20% by mass or less, and more preferably 3% by mass or more and 8% by mass or less. The concentration of the oxidizing agent in the etchant is preferably 1% by mass or more and 20% by mass or less, and more preferably 12% by mass or more and 18% by mass or less.

In the etching step, the noble metal catalyst 5 acts, and the substrate 1 is etched by the etchant to form a groove 6 in the substrate 1 as shown in Fig. 1C. In Fig. 1C, although an embodiment in which a through-groove is formed in the substrate 1 as the groove 6 is shown, a hole (through-hole) penetrating the substrate 1 may be formed by varying the shape of the mask 3. Further, a hole or groove that does not penetrate the substrate 1 may be formed. When the etching method of the present invention includes the noble metal catalyst supporting step, in the etching step, the region 4 of the substrate 1 is etched, the region being in contact with the noble metal catalyst 5, that is, a region immediately below the noble metal catalyst 5 of the substrate 1.

The time for bringing the etchant into contact with the substrate 1 is, for example, 120 minutes or more, or even 300 minutes or more. By bringing into contact with each other for a long time in this way, it is possible, for example, to penetrate the substrate 1 having a thickness of 100 um or more, or to form a deep hole or a groove in the substrate 1. For example, a through-hole having a small diameter or a through-groove having a narrow width, for example, a hole having a diameter of 10 um or less or a groove having a width of 10 um or less can be formed in the thick substrate 1 having a thickness of 100 um or more.

Here, in the present invention, the mask (protective film) 3 is formed using the photosensitive resin composition described above, that is, the photosensitive resin composition which provides a cured product (mask) having an extremely excellent resolution and extremely high etching resistance. Therefore, even if a cured product having a fine transfer pattern (mask) is formed and the mask is brought into contact with the etchant for a long time, the mask 3 does not peel off from the substrate, almost no cracks occur, the pattern shape of the mask having fine holes or grooves can be maintained, and the mask can function as the etching mask. Therefore, holes having a diameter of 10 um or less or grooves having a width of 10 um or less can be satisfactorily formed in the substrate 1. For example, it is possible to form a through hole or a through groove having an aspect ratio of 1 or more in the substrate 1, including to form a through-hole or a through-groove in the substrate 1 having a thickness of 100 um or more, or to form a deep hole or a groove in the substrate 1. Note that, since the above-described photosensitive resin composition can also form a cured product in which a surface of a side wall inside the pattern is smooth, influence on etching that occurs when the side wall inside the pattern has irregularity is suppressed, so that a desired hole or groove is easily formed on the substrate. Further, since inhibition of the catalytic action of the noble metal catalyst 5 and inhibition of the action of the etchant by components remaining in the region 4 are suppressed, etching can be performed satisfactorily over a long period of time.

### <Stripping step>

In the stripping step, the patterned cured product (mask 3) after the etching step is stripped off from the substrate 1. The method for stripping the mask 3 is not particularly limited, but for example, the method of contacting the mask 3 with a stripping solution, and an immersion method, a spraying method, a showering method, a paddle method, etc. may be used. Examples of the stripping solution include a nitrogen-containing basic organic compound and an organic solvent.

The nitrogen-containing basic organic compound is not particularly limited, as long as the mask 3 can be removed, and examples thereof include organic amines such as monoethanolamine, diethanolamine, triethanolamine, etc. and quaternary ammonium hydroxide such as tetramethylammonium hydroxide. The organic solvent is not particularly limited as long as it can remove the mask 3, and may be appropriately selected from the above-mentioned solvents (S). The organic solvent is preferably a polar solvent (in particular, ketones or monoethers of glycols in the above-mentioned solvent (S)), from the viewpoint of the process after the stripping step. From the viewpoint of a margin of the removing step, preferable examples thereof include aprotic polar organic solvents such as N-methylformamide, N,N-dimethylformamide, N-methylformanilide, N-methylacetamide, N,N-dimethylacetamide, N-methyl-2-pyrrolidone, dimethylsulfoxide, and the like. Two or more types of these nitrogen-containing basic organic compounds or organic solvents may also be used in combination. When the negative-type photosensitive resin composition is used, the stripping solution is preferably an organic solvent containing a nitrogen-containing basic organic compound.

The temperature of the stripping solution to be used for stripping the mask 3 is not particularly limited. In order to improve the stripping property, heating may be performed. The temperature of the stripping solution is, for example, preferably 5°C or more and 80°C or less, and more preferably 10°C or more and 60°C or less.

The contact time of the mask 3 and the stripping solution is not particularly limited as long as stripping of the mask can be carried out satisfactorily. The contact time is, for example, preferably 1 minute or more and 60 minutes or less, and more preferably 1 minute or more and 15 minutes or less.

### <Pretreatment step>

It is preferable that the etching method of the present invention has a pretreatment step of applying at least one selected from a silylating agent and a silane coupling agent to a surface of the substrate 1 on a side on which the photosensitive resin composition is to be applied before the coating step. By having the pretreatment step, side etching in which a side surface is etched in the etching step can be suppressed. Further, by having the pretreatment step, adhesion of the mask 3 to the substrate 1 is improved, so that etching resistance of the mask 3 can be further improved.

Examples of the silylating agent include hexamethyldisilazane (HMDS), N,N-dimethylaminotrimethylsilane (TMSDMA), and the like.

The silane coupling agent includes a ureide group-containing silane coupling agent and an amino group-containing silane coupling agent. Examples include ureidoalkyltrialkoxysilanes such as 3-ureidopropyltriethoxysilane, etc., 3-aminopropyltrimethoxysilane, 3-aminopropyltriethoxysilane, N-(2-aminoethyl)-3-aminopropylmethyldimethoxysilane, N-(2-aminoethyl)-3-aminopropyltrimethoxysilane, N-(2-aminoethyl)-3-aminopropyltriethoxysilane, 3-[2-(2-aminoethylaminoethylamino)propyl]trimethoxysilane, and the like.

In the pretreatment step, it is preferable to provide heating, after applying at least one selected from the silylating agent and the silane coupling agent to the surface of the substrate 1 on the side on which the photosensitive resin composition is to be applied. It is preferable to have a pretreatment step of heating. Heating conditions are usually 70°C or more and 200°C or less, and preferably 80°C or more and 150°C or less, and about 2 minutes or more and 120 minutes or less.

As described above, according to the etching method of the present invention, it is possible to form holes having a small diameter and grooves having a narrow width on the semiconductor substrate. For this reason, the etching method of the present invention can be preferably used, for example, in an application in which a TSV (through-silicon via) having a small diameter or a groove having a narrow width for dicing is formed in the semiconductor substrate.

### EXAMPLES

Hereinafter, the present invention is specifically described by way of the Examples and the Comparative Examples. The present invention is not at all limited to the Examples below.

### [Examples 1 to 5 and Comparative Example 1]

Components in ratios described in the following Table were mixed to obtain photosensitive resin compositions. A use amount of each component described in Table 1 is described as part by mass. The following components in Table 1 are as follows.

**[Table 1]**

| | | Example 1 | Example 2 | Example 3 | Example 4 | Example 5 | Comparative Example 1 |
|---|---|---|---|---|---|---|---|
| Resin (A) | A- 1 | 100 | 100 | 100 | - | - | - |
| | A-2 | - | - | - | 100 | - | - |
| | A-3 | - | - | - | - | 100 | - |
| | A-4 | - | - | - | - | - | 100 |
| Photosensitizer (B) | B - 1 | 0.5 | 0.5 | 0.5 | - | - | - |
| | B - 2 | - | - | - | 40 | - | - |
| | B - 3 | - | - | - | - | 0.5 | - |
| | B - 4 | - | - | - | - | - | 3 |
| Crosslinking agent | C-1 | 10 | 10 | 10 | - | - | - |
| | C-2 | - | - | - | - | - | 100 |
| Barium sulfate particles | D- 1 | 40 | - | - | 40 | 40 | 40 |
| | D-2 | - | 40 | - | - | - | - |
| Plasticizer | E-1 | 20 | 20 | 20 | 20 | 20 | - |
| Solvent(S) | S-1 | 140 | 140 | 130 | 200 | 130 | 240 |
| | S-2 | 30 | 30 | - | - | 30 | - |

### <Resin component (A)>

A-1: Novolak resin with m-cresol/p-cresol = 6/4 (molar ratio). (Mw: 10,000)
A-2: Novolak resin with m-cresol/p-cresol = 6/4 (molar ratio). (Mw: 35,000)
A-3: Novolak resin in which 7.5% of all phenolic hydroxy group is protected by an acid-dissociable dissolution-inhibiting group derived from 1,4-cyclohexanedimethanol divinyl ether. (Mw: 40,000, m-cresol/p-cresol = 6/4 (molar ratio) for novolak resin before protection.)
A-4: Acrylic resin of methacrylic acid/styrene/glycidyl methacrylate = 35/35/30 (by mass ratio) (Mw: 55,000)

### <Photosensitizer (B)>

B-1: Acid generator: 2,4-bis(trichloromethyl)-6-piperonyl-1,3,5-triazine
B-2: Compound having a naphthoquinonediazide group: a condensate of 4,4'-[1-[4-[1-[4-hydroxyphenyl]-1-methylethyl]phenyl]ethylidene]bisphenol (1 mol) and 1,2-naphthoquinonediazido-5-sulfonic acid chloride (2 mol), i.e., (4,4 '-[1-[4-[1-[4-hydroxyphenyl]-1-methylethyl]phenyl]ethylidene]bisphenol-1,2-naphthoquinonediazido-5-sulfonate ester)
B-3: Acid generator: triphenylsulfonium nonafluorobutanesulfonate
B-4: Polymerization initiator: A mixture of 2-methyl-1-1-[4-(methylthio)phenyl]-2-morpholinopropane-1-one and 2,4-diethylthioxanthone (mass ratio 70:30)

### <Crosslinking agent>

C-1: 2,4,6-tris[bis(methoxymethyl)amino]-1,3,5-triazine
C-2: Acrylic monomer: A mixture of bisphenol A epoxy acrylate and trimethylolpropane triacrylate (mass ratio 75:25)

### <Barium sulfate particles>

D-1: Bariace B-30 (spherical barium sulfate particles with an average particle diameter of 300 nm, manufactured by Sakai Chemical Industry Co., Ltd.)
D-2: Barifine BF-20 (spherical barium sulfate particles with an average particle diameter of 20 nm, manufactured by Sakai Chemical Industry Co., Ltd.)

### <Plasticizer>

E-1: Polyvinyl methyl ether (mass average molecular weight: 100,000)

### <Solvent (S)>

S-1: Propylene glycol monomethyl ether acetate (PGMEA)
S-2: 3-Methoxybutyl acetate (MA)

### <Evaluation of resolution and shape>

Using each of the photosensitive resin compositions of Examples 1 to 5 and Comparative Example 1 obtained, a patterned cured products (mask) was formed on a silicon substrate according to the following method. Note that as the silicon substrate, two types of silicon substrates were used: a silicon substrate subjected to the pretreatment step of applying a pretreatment agent (a propylene glycol methyl ether solution containing 1% by mass of 3-ureidopropyltriethoxysilane) and a silicon substrate not subjected to the pretreatment step. When the pretreatment step was performed, a heat treatment was performed at 130°C for 5 minutes after the application of the pretreatment agent.

First, a photosensitive resin composition was coated on a silicon substrate having a thickness of 150 um. Then, the coating film was dried under reduced pressure at room temperature for 5 minutes, heated at 90°C for 5 minutes, and then heated at 120°C for 5 minutes. The coating film after heating was subjected to exposure via a negative-type mask for forming an isolated space pattern in Examples 1 to 3 and Comparative Example 1, and via a positive-type mask for forming an isolated space pattern in Examples 4 and 5. This exposure was performed at an exposure amount of 700 mJ/cm² with i-line (365 nm) in Examples 1 to 3 and Comparative Example 1, and at an exposure amount of 2,000 mJ/cm² with i-line (365 nm) in Examples 4 to 5. The coating film after exposure was heated at 115°C for 3 minutes in Examples 1 to 3, and at 150°C for 3 minutes in Example 5. Note that, in Example 4 and Comparative Example 1, heating was not performed after this exposure. Then, the coating film after heating in each of Examples 1 to 3 and 5, and the coating film after exposure in each of Example 4 and Comparative Example 1 were brought into contact with an aqueous tetramethylammonium hydroxide solution having a concentration of 2.38% by mass at 22°C for 15 minutes, so that development was performed. The developed coating films were rinsed with pure water for 1 minute at room temperature and then heated (PSB) to form a patterned cured product having a thickness of 50 um. This heating (PSB) was performed at 140°C for 15 minutes or at 200°C for 15 minutes in Examples 1 to 3 and Comparative Example 1; at 100°C for 30 minutes in Example 4; and at 120°C for 30 minutes in Example 5. Note that with respect to Example 1, step baking including heating at 140°C for 5 minutes and then heating at 200°C for 10 minutes was also performed and evaluated. As a result, it was confirmed that the results of the step baking are equivalent to those single baking as shown in Table 1.

The resulting isolated space patterns were observed by a scanning electron microscope (SEM), and when an isolated space pattern in which the groove width was 3 um or less was formed, the resolution was evaluated as very good (indicated by a concentric circle symbol (⊙)), when an isolated space pattern in which the groove width was more than 3 um and 10 um or less was formed, the resolution was evaluated as good (indicated by a circle symbol (o)), and when an isolated space pattern in which the groove width was more than 10 um was formed, the resolution was evaluated as poor (indicated by a cross symbol (x)). Results are shown in Table 2.

Further, the resulting isolated space patterns were observed by scanning electron microscopy (SEM). When a surface of a side wall inside the isolated space pattern was smooth, the shape was evaluated as very good (indicated by a concentric circle symbol (⊙)), and when fine irregularities (roughness) appeared on the surface of the side wall inside the isolated space pattern, the shape was evaluated as good (indicated by a circle symbol(o)). Results are shown in Table 2.

### <Evaluation of etching resistance (peeling and cracking)>

The same operation as in <Evaluation of resolution and shape> was performed to obtain silicon substrates each comprising a patterned cured product, except that each isolated space pattern (cured product) having a width of 5 um, 10 um, or 15 um was formed on the silicon substrate by changing the mask. The resulting silicon substrates provided with the cured product were subjected to a Pt sputtering treatment by vapor deposition machine to form a Pt layer having a thickness of about 100 nm. Thereafter, the etching treatment was carried out with stirring at 300 rpm for 120 minutes or 300 minutes at room temperature (25°C) in the following etchant, and the etching resistance was evaluated on the basis of the following criteria. Results are shown in Table 2. Note that it was confirmed that etching of each of the silicon substrates progressed in the lower layer of the isolated space portion and grooves were formed in the silicon substrate. On the other hand, when no Pt sputtering treatment was performed, even when the same etching treatment was performed, etching of the silicon substrate of the lower layer did not progress.
Etchant: an aqueous solution having a concentration of hydrogen fluoride of 5% by mass and a concentration of hydrogen peroxide of 15% by mass
Peeling: During the etching treatment, a sample in which all of the isolated space patterns (cured products) of a width of 5 um, 10 µm, and 15 um were peeled off was evaluated as poor (indicated by cross symbol (x)), a sample in which the isolated space patterns were not peeled off after the etching treatment for 120 minutes but were peeled off after the etching treatment for 300 minutes was evaluated as good (indicated by a circle symbol (o)), and a sample in which the isolated space pattern was not peeled off either after the etching treatment for 120 minutes or after the etching treatment for 300 minutes was evaluated as very good (indicated by a concentric circle symbol (⊙)).
Crack: a sample in which cracks occurred in the isolated space pattern (cured product) after the etching treatment was evaluated as fair (indicated by triangle symbol (Δ)), and a sample in which no cracks occurred was evaluated as good (indicated by circle symbol (o)). Note that in the evaluation of cracks, samples in which the cured product was peeled off during the etching treatment were not evaluated.

### <Evaluation of stripping property>

A silicon substrate comprising a patterned cured product was obtained by performing the same operation as in the <Evaluation of resolution and shape>. A silicon substrate comprising a patterned cured product was immersed in a mixed solvent (monoethanolamine (MEA)/dimethyl sulfoxide (DMSO) (mass ratio) = 70/30) warmed to 60°C in Examples 1 to 3 and Comparative Example 1, and immersed in a mixed solvent (N-methyl-2-pyrrolidone (NMP)/dimethyl sulfoxide (DMSO) (mass ratio) = 40/60) at room temperature in Examples 4 to 5. Stripping property was evaluated in the following manner: A sample in which the cured product dissolved and was stripped in less than 10 minutes was evaluated as very good (indicated by concentric circle (⊙)), a sample in which the cured product swelled and was stripped in less than 10 minutes was evaluated as good (indicated by circle symbol (o)), and a sample in which the cured product was not stripped even after 10 minutes or more was evaluated as poor (indicated by cross symbol (x)). Results are shown in Table 2.

As shown in Table 2, in Examples 1 to 5, none of the patterned cured products peeled off even after 120 minutes had elapsed after contact with the etchant. In particular, in Examples 1, 3, and 4, although the PSB temperature was low or the pretreatment step was necessary in some cases, it can be seen that in all of Examples 1, 3, and 4, there was a condition under which the patterned cured product did not peel off even after 300 minutes had elapsed after contact with the etchant. For this reason, it can be seen that in Examples 1 to 5, since the silicon substrates could be etched for 120 minutes or more under such conditions, not only shallow holes or grooves but also deep holes or grooves could be formed, and that through-holes or through-grooves could be formed even in a thick substrate of, for example, 100 um or more. In addition, in Examples 1 to 5, the photosensitive resin compositions had a high resolution and formed cured products which had space patterns of a small groove having a width of 10 um or less. In particular, in Example 2, the photosensitive resin composition had an extremely high resolution and formed a patterned cured product having a space pattern of a small groove having a width of 3 um or less. Therefore, in Examples 1 to 5, holes or grooves having a high aspect ratio could be formed. In Examples 2 to 3, cured products having a side wall the surface of which was smooth could be obtained. It can also be seen that in Examples 1 to 5, the patterned cured products could be easily stripped from the substrates by an organic solvent. Note that in Examples 1 to 5, when the pretreatment step was performed, side etching was suppressed as compared with a case where the pretreatment step was not performed.

**[Table 2]**

| | Example 1 | | | | Example 2 | | | | Example 3 | | | | Example 4 | | Example 5 | | Comparative Example 1 | | | |
|---|---|---|---|---|---|---|---|---|---|---|---|---|---|---|---|---|---|---|---|---|
| PSB temperature (°C) | 140 | 140 | 200 | 200 | 140 | 140 | 200 | 200 | 140 | 140 | 200 | 200 | 100 | 100 | 120 | 120 | 140 | 140 | 200 | 200 |
| Pretreatment step | Yes | No | Yes | No | Yes | No | Yes | No | Yes | No | Yes | No | Yes | No | Yes | No | Yes | No | Yes | No |
| Resolution | ○ | ○ | ○ | ○ | ⊙ | ⊙ | ⊙ | ⊙ | ○ | ○ | ○ | ○ | ○ | ○ | ○ | ○ | ○ | ○ | ○ | ○ |
| Shape | ○ | ○ | ○ | ○ | ⊙ | ⊙ | ⊙ | ⊙ | ⊙ | ⊙ | ○ | ⊙ | ○ | ○ | ○ | ○ | ○ | ○ | ○ | ○ |
| Etching resistance (peeling) | ⊙ | ⊙ | ⊙ | ⊙ | ○ | ○ | ○ | ○ | ⊙ | ○ | ○ | ○ | ⊙ | ○ | ○ | ○ | X | X | X | x |
| Etching resistance (crack) | ○ | ○ | ○ | ○ | ○ | ○ | ○ | ○ | ○ | ○ | ○ | ○ | Δ | Δ | Δ | Δ | - | - | - | - |
| Stripping property | O | ○ | ○ | ○ | ○ | ○ | ○ | ○ | ○ | ○ | ○ | ○ | ⊙ | ⊙ | ⊙ | ⊙ | X | X | x | x |

### EXPLANATION OF REFERENCE NUMERALS

- 1: Substrate
- 2: Dicing tape
- 3: Mask (protective film)
- 4: Region
- 5: Noble metal catalyst
- 6: Groove

## Claims

1. An etching method, comprising:
a coating step of forming a coating film by applying a photosensitive resin composition to a substrate,
an exposure step of position-selectively exposing the coating film,
a developing step of developing the coating film after exposure to expose a part of the substrate and obtain a patterned cured product,
an etching step of etching the substrate to form a hole or groove in the substrate, with the etching being performed in the presence of a noble metal catalyst using the patterned cured product as a mask and an aqueous solution including a corrosive agent and an oxidizing agent as an etchant, and
a stripping step of stripping the patterned cured product after the etching step, from the substrate,
wherein the photosensitive resin composition comprises a resin (A), a photosensitizer (B), a plasticizer, and a solvent (S), and
wherein the resin (A) is a novolak resin, and the plasticizer is polyvinyl alkyl ether, wherein the content of the plasticizer in the photosensitive resin composition is 5 parts by mass or more and 100 parts by mass or less with respect to 100 parts by mass of the novolak resin.

2. The etching method according to claim 1, further comprising a noble metal catalyst supporting step of making an exposed region of the substrate support the noble metal catalyst, after the developing step and before the etching step,
wherein a region of the substrate is etched in the etching step, the region being in contact with the noble metal catalyst.

3. The etching method according to claim 1 or 2, further comprising a pretreatment step of applying at least one selected from a silylating agent and a silane coupling agent to a surface of the substrate on a side on which the photosensitive resin composition is to be applied before the coating step.

4. The etching method according to any one of claims 1 to 3, wherein the substrate is a semiconductor substrate.

5. The etching method according to any one of claims 1 to 4, wherein a hole having a diameter of 10 µm or less or a groove having a width of 10 µm or less is formed in the substrate.

6. The etching method according to any one of claims 1 to 5, wherein the oxidizing agent comprises hydrogen peroxide or nitric acid.

7. The etching method according to any one of claims 1 to 6, wherein a film thickness of the patterned cured product is 25 µm or more.

8. The etching method according to any one of claims 1 to 7, wherein the photosensitive resin composition comprises barium sulfate particles having an average particle diameter of 500 nm or less.

9. The etching method according to any one of claims 1 to 8,
wherein the photosensitive resin composition comprises a crosslinking agent,
wherein the photosensitizer (B) is an acid generator, and
wherein the novolak resin is a resin capable of being crosslinked by the crosslinking agent by an action of an acid generated from the acid generator by exposure.

10. The etching method according to any one of claims 1 to 8,
wherein the photosensitizer (B) is a compound having a naphthoquinonediazide group, and
wherein the novolak resin is an alkali-soluble novolak resin.

11. The etching method according to any one of claims 1 to 8,
wherein the photosensitizer (B) is an acid generator, and
wherein the novolak resin is a resin whose solubility in alkali is increased by an action of an acid generated from the acid generator by exposure.

12. The etching method according to any one of claims 1 to 8, wherein the photosensitive resin composition comprises barium sulfate particles having an average particle diameter of 200 nm or less.

13. The etching method according to claim 2, wherein the noble metal catalyst is supported by a vapor phase deposition method, in the noble metal catalyst supporting step.

14. A photosensitive resin composition for use in the etching method according to any one of claims 1 to 13,
the photosensitive resin composition comprising the resin (A), the photosensitizer (B), a plasticizer, and the solvent (S),
wherein the resin (A) is the novolak resin, and the plasticizer is polyvinyl alkyl ether, wherein the content of the plasticizer in the photosensitive resin composition is 5 parts by mass or more and 100 parts by mass or less with respect to 100 parts by mass of the novolak resin.

## Patentansprüche

1. Ätzverfahren, umfassend:
einen Beschichtungsschritt des Ausbildens eines Beschichtungsfilms durch Aufbringen einer photoempfindlichen Harzzusammensetzung auf ein Substrat,
einen Belichtungsschritt des positionsselektiven Belichtens des Beschichtungsfilms,
einen Entwicklungsschritt des Entwickelns des Beschichtungsfilms nach Belichtung, um einen Teil des Substrats freizulegen und ein strukturiertes gehärtetes Produkt zu erhalten,
einen Ätzschritt des Ätzens des Substrats, um ein Loch oder eine Rille in dem Substrat zu bilden, wobei das Ätzen in der Gegenwart eines Edelmetallkatalysators unter Verwendung des strukturierten gehärteten Produkts als Maske und einer wässrigen Lösung umfassend ein korrosives Mittel und ein Oxidationsmittel als ein Ätzmittel durchgeführt wird, und
einen Ablöseschritt des Ablösens des strukturierten gehärteten Produkts nach dem Ätzschritt von dem Substrat,
wobei die photoempfindliche Harzzusammensetzung ein Harz (A), einen Photosensibilisator (B), einen Weichmacher und ein Lösungsmittel (S) umfasst, und
wobei das Harz (A) ein Novolakharz ist und der Weichmacher Polyvinylalkylether ist, wobei der Gehalt des Weichmachers in der photoempfindlichen Harzzusammensetzung 5 Masseteile oder mehr und 100 Masseteile oder weniger, bezogen auf 100 Masseteile des Novolakharzes, beträgt.

2. Ätzverfahren nach Anspruch 1, ferner umfassend einen Edelmetallkatalysator-Auftrageschritt des Bewirkens, dass ein freiliegender Bereich des Substrats den Edelmetallkatalysator trägt, nach dem Entwicklungsschritt und vor dem Ätzschritt,
wobei ein Bereich des Substrats in dem Ätzschritt geätzt wird, wobei der Bereich in Kontakt mit dem Edelmetallkatalysator steht.

3. Ätzverfahren nach Anspruch 1 oder 2, ferner umfassend einen Vorbehandlungsschritt des Auftragens von mindestens Einem ausgewählt aus einem Silylierungsmittel und einem Silankupplungsmittel auf eine Oberfläche des Substrats auf einer Seite, auf der die photoempfindliche Harzzusammensetzung vor dem Beschichtungsschritt aufzutragen ist.

4. Ätzverfahren nach einem der Ansprüche 1 bis 3, wobei das Substrat ein Halbleitersubstrat ist.

5. Ätzverfahren gemäß einem der Ansprüche 1 bis 4, wobei ein Loch mit einem Durchmesser von 10 µm oder weniger oder eine Rille mit einer Breite von 10 µm oder weniger in dem Substrat ausgebildet wird.

6. Ätzverfahren nach einem der Ansprüche 1 bis 5, wobei das Oxidationsmittel Wasserstoffperoxid oder Salpetersäure umfasst.

7. Ätzverfahren nach einem der Ansprüche 1 bis 6, wobei die Filmdicke des strukturierten gehärteten Produkts 25 µm oder mehr beträgt.

8. Ätzverfahren nach einem der Ansprüche 1 bis 7, wobei die photoempfindliche Harzzusammensetzung Bariumsulfatpartikel mit einem durchschnittlichen Partikeldurchmesser von 500 nm oder weniger umfasst.

9. Ätzverfahren nach einem der Ansprüche 1 bis 8,
wobei die photoempfindliche Harzzusammensetzung ein Vernetzungsmittel umfasst, wobei der Photosensibilisator (B) ein Säurebildner ist und
wobei das Novolakharz ein Harz ist, das dazu fähig ist, durch das Vernetzungsmittel durch die Wirkung einer Säure, die durch Belichtung aus dem Säurebildner erzeugt wird, vernetzt zu werden.

10. Ätzverfahren nach einem der Ansprüche 1 bis 8,
wobei der Photosensibilisator (B) eine Verbindung mit einer Naphthochinondiazidgruppe ist und
wobei das Novolakharz ein alkalilösliches Novolakharz ist.

11. Ätzverfahren nach einem der Ansprüche 1 bis 8,
wobei der Photosensibilisator (B) ein Säuregenerator ist und
wobei das Novolakharz ein Harz ist, dessen Löslichkeit in Alkali durch die Wirkung einer Säure erhöht wird, die durch Belichtung aus dem Säuregenerator erzeugt wird.

12. Ätzverfahren nach einem der Ansprüche 1 bis 8, wobei die photoempfindliche Harzzusammensetzung Bariumsulfatpartikel mit einem durchschnittlichen Partikeldurchmesser von 200 nm oder weniger umfasst.

13. Ätzverfahren nach Anspruch 2, wobei der Edelmetallkatalysator durch ein Gasphasenabscheidungsverfahren im Edelmetallkatalysator-Auftrageschritt aufgetragen wird.

14. Eine photoempfindliche Harzzusammensetzung zur Verwendung in dem Ätzverfahren nach einem der Ansprüche 1 bis 13,
wobei die photoempfindliche Harzzusammensetzung das Harz (A), den Photosensibilisator (B), einen Weichmacher und das Lösungsmittel (S) umfasst,
wobei das Harz (A) das Novolakharz ist und der Weichmacher Polyvinylalkylether ist, wobei der Gehalt des Weichmachers in der photoempfindlichen Harzzusammensetzung 5 Masseteile oder mehr und 100 Masseteile oder weniger, bezogen auf 100 Masseteile des Novolakharzes, beträgt.

## Revendications

1. Procédé de gravure, comprenant :
une étape de revêtement consistant à former un film de revêtement en appliquant une composition de résine photosensible sur un substrat,
une étape d'exposition consistant à exposer sélectivement par rapport à la position le film de revêtement,
une étape de développement consistant à développer le film de revêtement après l'exposition pour exposer une partie du substrat et obtenir un produit durci à motifs, une étape de gravure consistant à graver le substrat pour former un trou ou une rainure dans le substrat, la gravure étant réalisée en présence d'un catalyseur en métal noble en utilisant le produit durci à motifs comme un masque et une solution aqueuse comportant un agent corrosif et un agent oxydant comme agent de gravure, et
une étape de décapage consistant à décaper le produit durci à motifs après l'étape de gravure, à partir du substrat,
dans lequel la composition de résine photosensible comprend une résine (A), un photosensibilisant (B), un plastifiant et un solvant (S), et
dans lequel la résine (A) est une résine Novolaque, et le plastifiant est un éther d'alkyle polyvinylique, dans lequel la teneur en plastifiant dans la composition de résine photosensible est de 5 parties en masse ou plus et de 100 parties en masse ou moins par rapport à 100 parties en masse de la résine Novolaque.

2. Procédé de gravure selon la revendication 1, comprenant en outre une étape de support de catalyseur en métal noble consistant à faire d'une région exposée du support de substrat le catalyseur en métal noble, après l'étape de développement et avant l'étape de gravure,
dans lequel une région du substrat est gravée dans l'étape de gravure, la région étant en contact avec le catalyseur en métal noble.

3. Procédé de gravure selon la revendication 1 ou 2, comprenant en outre une étape de pré-traitement consistant à appliquer au moins un agent sélectionné parmi un agent de silylation et un agent de couplage de silane sur une surface du substrat sur un côté sur lequel la composition de résine photosensible doit être appliquée avant l'étape de durcissement.

4. Procédé de gravure selon l'une quelconque des revendications 1 à 3, dans lequel le substrat est un substrat semiconducteur.

5. Procédé de gravure selon l'une quelconque des revendications 1 à 4, dans lequel un trou ayant un diamètre de 10 µm ou moins ou une rainure présentant une largeur de 10 µm ou moins est formé(e) dans le substrat.

6. Procédé de gravure selon l'une quelconque des revendications 1 à 5, dans lequel l'agent oxydant comprend du peroxyde d'hydrogène ou de l'acide nitrique.

7. Procédé de gravure selon l'une quelconque des revendications 1 à 6, dans lequel une épaisseur de film du produit durci à motifs est de 25 µm ou plus.

8. Procédé de gravure selon l'une quelconque des revendications 1 à 7, dans lequel la composition de résine photosensible comprend des particules de sulfate de baryum ayant un diamètre de particules moyen de 500 nm ou moins.

9. Procédé de gravure selon l'une quelconque des revendications 1 à 8,
dans lequel la composition de résine photosensible comprend un agent de réticulation, dans lequel le photosensibilisant (B) est un générateur d'acide, et
dans lequel la résine Novolaque est une résine apte à être réticulée par l'agent de réticulation par une action d'un acide généré à partir du générateur d'acide par exposition.

10. Procédé de gravure selon l'une quelconque des revendications 1 à 8,
dans lequel le photosensibilisant (B) est un composé ayant un groupe naphthoquinonediazide, et
dans lequel la résine Novolaque est une résine Novolaque soluble en milieu alcalin.

11. Procédé de gravure selon l'une quelconque des revendications 1 à 8,
dans lequel le photosensibilisant (B) est un générateur d'acide, et
dans lequel la résine Novolaque est une résine dont la solubilité en milieu alcalin est augmentée par une action d'un acide généré à partir du générateur d'acide par exposition.

12. Procédé de gravure selon l'une quelconque des revendications 1 à 8, dans lequel la composition de résine photosensible comprend des particules de sulfate de baryum ayant un diamètre de particules moyen de 200 nm ou moins.

13. Procédé de gravure selon la revendication 2, dans lequel le catalyseur en métal noble est supporté par un procédé de dépôt en phase vapeur, dans l'étape de support de catalyseur en métal noble.

14. Composition de résine photosensible destinée à être utilisée dans le procédé de gravure selon l'une quelconque des revendications 1 à 13,
la composition de résine photosensible comprenant la résine (A), le photosensibilisant (B), un plastifiant et le solvant (S),
dans laquelle la résine (A) est la résine Novolaque, et le plastifiant est un éther d'alkyle polyvinylique, dans laquelle la teneur en plastifiant dans la composition de résine photosensible est de 5 parties en masse ou plus et de 100 parties en masse ou moins par rapport à 100 parties en masse de la résine Novolaque.
